# EUROPEAN PATENT APPLICATION

(11) **EP 4 372 789 A1**
(43) Date of publication of application: **22.05.2024**
(21) Application number: 21952169.7
(22) Date of filing: 02.08.2021
(51) Int. Cl.: H01L 21/60, H01L 23/498, H01L 23/48, H01L 23/522

(54) **CHIP STACKED STRUCTURE AND MANUFACTURING METHOD THEREFOR, AND CHIP PACKAGING STRUCTURE, AND ELECTRONIC DEVICE**

(71) Applicant: Huawei Technologies Co., Ltd., Shenzhen, Guangdong 518129 (CN)
(72) Inventor: WU, Eric, Shenzhen, Guangdong 518129 (CN); ZHU, Jifeng, Shenzhen, Guangdong 518129 (CN)
(74) Representative: Isarpatent
(86) International application number: PCT/CN2021/110155
(87) International publication number: WO 2023/010259

(57) **Abstract**

Embodiments of this application provide a chip stacked structure and a manufacturing method thereof, a chip package structure, and an electronic device, and relate to the field of chip technologies, to reduce difficulty in manufacturing a through silicon via in the chip stacked structure. The chip stacked structure includes a first chip and a second chip. The first chip includes a first substrate, a first functional layer, and first through silicon vias. A diameter of the first through silicon via close to the first functional layer is greater than a diameter of the first through silicon via close to the first substrate. The second chip includes a second substrate and a second functional layer. The chip stacked structure further includes a first redistribution layer disposed on a side that is of the second functional layer and that is away from the second substrate, a first dielectric layer disposed between the first substrate and the first redistribution layer, and a plurality of first bonding metal blocks disposed in the first dielectric layer. At least some of the first bonding metal blocks are electrically connected to the first through silicon vias and the first redistribution layer respectively. The first chip and the second chip are bonded through the first dielectric layer and the first bonding metal blocks.

## Description

### TECHNICAL FIELD

This application relates to the field of chip technologies, and in particular, to a chip stacked structure and a manufacturing method thereof, a chip package structure, and an electronic device.

### BACKGROUND

With rapid development of semiconductor technologies, a 3D IC (three-dimensional integrated circuit, three-dimensional integrated circuit) has been widely applied. The 3D IC means that a plurality of chips are vertically integrated and stacked in three-dimensional space, to reduce a package size, improve chip performance, improve chip integration, and the like. The 3D IC technology has been successfully applied by many semiconductor manufacturers to produce products such as a CMOS (complementary metal oxide semiconductor, complementary metal oxide semiconductor) image sensor, a NAND flash (flash memory), and a high-bandwidth memory (high bandwidth memory, HBM), and greatly improve product performance.

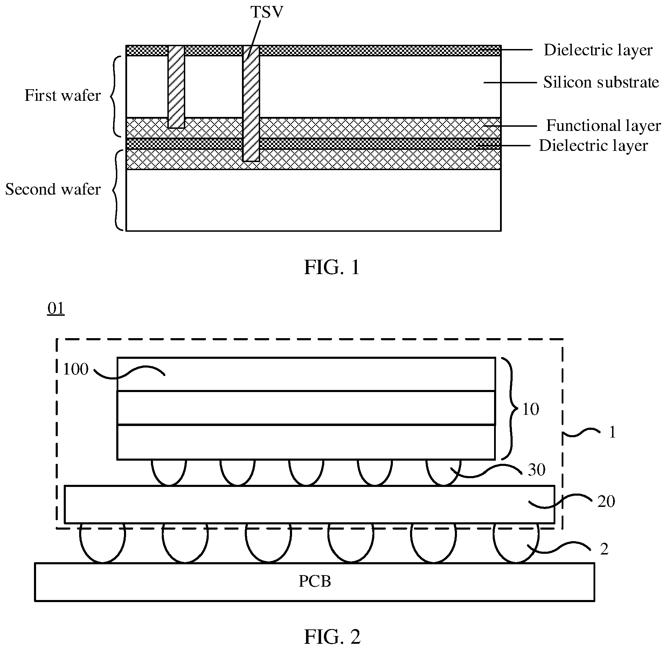

At present, a wafer bonding technology is mainly used to implement two-layer stacking between wafers. Specifically, as shown in FIG. 1, a first wafer and a second wafer are bonded through a dielectric layer (dielectric), and the first wafer and the second wafer are interconnected to the outside through a through silicon via (through silicon via, TSV). Refer to FIG. 1. The first wafer and the second wafer each include a silicon (silicon) substrate and a functional layer disposed on the silicon (silicon) substrate. The functional layer includes a functional device, a circuit structure, an interconnection metal wire, a dielectric layer, and the like. When the first wafer and the second wafer are stacked by using the wafer bonding technology, the first wafer and the second wafer are first bonded through the dielectric layer, and the functional layer of the first wafer is close to the functional layer of the second wafer. The TSV is then manufactured from a side of the silicon substrate of the first wafer. To prevent the silicon substrate of the first wafer from being polluted during etching of the TSV, a dielectric layer is formed on the silicon substrate of the first wafer. In this way, when the TSV is manufactured from the side of the silicon substrate of the first wafer, at least the dielectric layer on the silicon substrate of the first wafer, the silicon substrate of the first wafer, and the dielectric layer in the functional layer of the first wafer need to be etched in an etching process. In other words, at least the dielectric layer, the silicon substrate, and the dielectric layer need to be etched sequentially during manufacturing of the TSV. This increases difficulty in etching the TSV. In addition, when the TSV is manufactured from the side of the silicon substrate of the first wafer, the process of manufacturing the TSV has a high requirement on a depth of the TSV, and the manufactured TSV should be in contact with the circuit structure in the functional layer, to implement an electrical connection between the TSV and the circuit structure. In this way, difficulty in etching the TSV is further increased, and there is a large technical challenge to the process.

### SUMMARY

Embodiments of this application provide a chip stacked structure and a manufacturing method thereof, a chip package structure, and an electronic device, to reduce difficulty in manufacturing a through silicon via in the chip stacked structure.

To achieve the foregoing objective, this application uses the following technical solutions.

According to a first aspect, a chip stacked structure manufacturing method is provided. The chip stacked structure manufacturing method includes: first, forming first through silicon vias on a first chip from a side of a first functional layer of the first chip, where the first chip includes a first substrate and the first functional layer disposed on the first substrate; next, bonding a carrier and the first chip, where the first functional layer is close to the carrier relative to the first substrate; next, forming a first redistribution layer on a second functional layer of a second chip, where the second chip includes a second substrate and the second functional layer disposed on the second substrate; and next, bonding the first chip and the second chip, and forming a first dielectric layer between the first substrate and the first redistribution layer and a plurality of first bonding metal blocks located in the first dielectric layer, where at least some of the first bonding metal blocks are electrically connected to the first through silicon vias and the first redistribution layer respectively. According to the chip stacked structure manufacturing method provided in this application, when the first through silicon via on the first chip is manufactured, the first through silicon via is formed from a side of the first functional layer of the first chip, that is, the first through silicon via is manufactured from the front side of the first chip. In this way, only the dielectric layer and the first substrate that are on the front side of the first chip need to be etched. When two-layer stacking between wafers is implemented through wafer bonding, the process of forming the through silicon via requires at least etching the dielectric layer in the functional layer on the front side of the chip, as well as etching the substrate and the dielectric layer on the back side of the chip (where the dielectric layer on the back side of the chip may include a flat layer, a hard mask, and the like). By contrast, in embodiments of this application, the process of etching the dielectric layer on the back side of the first chip is reduced in the process of forming the first through silicon via through etching. Therefore, the process of forming the first through silicon via in embodiments of this application is simpler. In addition, in this application, because the first through silicon via is formed from a side of the first functional layer of the first chip, in a process of manufacturing the first through silicon via, the first through silicon via may penetrate the first substrate or stop at any position in the first substrate. When a TSV is manufactured from a side of a silicon substrate of a first wafer, a high requirement is imposed on a depth of the TSV, and the manufactured TSV should be in contact with a circuit structure or an interconnection metal wire in a functional layer. By contrast, in this application, difficulty in manufacturing the first through silicon via can be further reduced.

When at least one of the first chip and the second chip is a wafer, in a stacking process of the first chip and the second chip, because a processing capability of the wafer is fine, the first bonding metal blocks formed between the first chip and the second chip may be made small. In this way, a pitch (pitch) between adjacent first bonding metal blocks is small, and the pitch between adjacent first bonding metal blocks may reach 0.5 µm to 15 µm, or even smaller. In this way, a density of the first bonding metal blocks disposed between the first chip and the second chip increases, so that an interconnection density between the first chip and the second chip can be increased, and an interconnection bandwidth between the first chip and the second chip can be increased. Compared with interconnection between adjacent chips implemented through a micro bump, when interconnection between the first chip and the second chip is implemented through the first bonding metal block, an interconnection density per square millimeter can be increased by more than 10 times, and even more than 1000 times at most.

In addition, when both the first chip and the second chip are wafers, because alignment precision between the wafer and the wafer is high, a size of a first bonding metal block formed between the first chip and the second chip may be further reduced, that is, a pitch between adjacent first bonding metal blocks may be further reduced, thereby further improving the interconnection density between the first chip and the second chip, and further improving the interconnection bandwidth between the first chip and the second chip.

In addition, the first chip and the second chip are directly bonded through the first dielectric layer and the first bonding metal block. Therefore, after the first chip and the second chip are stacked, there is no need to fill a filling material between the first chip and the second chip. In one aspect, the process can be simplified. In another aspect, because the filling material is generally an organic material, a substrate of the first chip and the second chip is generally a silicon substrate, and a difference between thermal expansion coefficients of the organic material and the silicon substrate is large, the filling material causes a stress matching problem. In addition, a material of the first dielectric layer is generally one or more of silicon nitride, silicon oxide, silicon oxynitride, silicon carbide, and the like, and silicon nitride, silicon oxide, silicon oxynitride, and silicon carbide have thermal expansion coefficients close to that of the silicon substrate. Therefore, this application can further avoid the stress matching problem caused by the filling material.

In a possible implementation, after the bonding the first chip and the second chip, and forming a first dielectric layer between the first substrate and the first redistribution layer and a plurality of first bonding metal blocks located in the first dielectric layer, the chip stacked structure manufacturing method further includes: removing the carrier, and forming a lead structure on a side of the first functional layer of the first chip, where the lead structure is electrically connected to the first through silicon via. Interconnection between the chip stacked structure and the outside can be implemented through the lead structure.

In a possible implementation, the first through silicon via does not penetrate the first substrate; and after the bonding a carrier and the first chip, and before the bonding the first chip and the second chip, and forming a first dielectric layer between the first substrate and the first redistribution layer and a plurality of first bonding metal blocks located in the first dielectric layer, the manufacturing method further includes: thinning the first substrate from a side that is of the first substrate and that is away from the first functional layer to expose the first through silicon via. When the first through silicon via is formed, the first through silicon via does not penetrate the first substrate, and the first through silicon via is subsequently exposed by thinning the first substrate. Therefore, when the first through silicon via is manufactured, only the dielectric layer on the front side of the first chip and a part of the first substrate need to be etched, thereby further reducing difficulty in manufacturing the first through silicon via.

In a possible implementation, the forming a first dielectric layer between the first substrate and the first redistribution layer and a plurality of first bonding metal blocks located in the first dielectric layer includes: forming a first dielectric sub-layer and a plurality of first bonding metal sub-blocks on the first substrate, where the first bonding metal sub-block is disposed in the first dielectric sub-layer, and is exposed on a surface that is of the first dielectric sub-layer and that is away from the first substrate, and at least some of the first bonding metal sub-blocks are electrically connected to the first through silicon vias; and forming a second dielectric sub-layer and a plurality of second bonding metal sub-blocks on the first redistribution layer, where the second bonding metal sub-block is disposed in the second dielectric sub-layer, and is exposed on a surface that is of the second dielectric sub-layer and that is away from the second substrate, and at least some of the second bonding metal sub-blocks are electrically connected to the first redistribution layer, where the first dielectric layer includes the first dielectric sub-layer and the second dielectric sub-layer, and the first bonding metal block includes the first bonding metal sub-block and the second bonding metal sub-block. When the first bonding metal sub-block and the second bonding metal sub-block are bonded, the first dielectric sub-layer and the second dielectric sub-layer are bonded, so that bonding of the first chip and the second chip can be implemented. In addition, because the first dielectric sub-layer and the second dielectric sub-layer are bonded, after the first chip and the second chip are bonded, there is no need to fill a filling material between the first chip and the second chip. Therefore, the process can be simplified, and the stress matching problem can be avoided.

In a possible implementation, the first dielectric sub-layer includes a plurality of first hybrid bonding vias in a one-to-one correspondence with the first through silicon vias, and the first bonding metal sub-blocks are electrically connected to the first through silicon vias through the first hybrid bonding vias; and/or the second dielectric sub-layer includes a plurality of second hybrid bonding vias, and the second bonding metal sub-blocks are electrically connected to the first redistribution layer through the second hybrid bonding vias. The first hybrid bonding via and the second hybrid bonding via are disposed to ensure that some first bonding metal sub-blocks are electrically connected to the first through silicon vias, and some second bonding metal sub-blocks are electrically connected to the first redistribution layer, to prevent other first bonding metal sub-blocks and second bonding metal sub-blocks from being electrically connected to the circuit structure. In this way, the plurality of formed first bonding metal sub-blocks and the plurality of formed second bonding metal sub-blocks can be evenly distributed.

In a possible implementation, after the bonding a carrier and the first chip, and before the bonding the first chip and the second chip, and forming a first dielectric layer between the first substrate and the first redistribution layer and a plurality of first bonding metal blocks located in the first dielectric layer, the manufacturing method further includes: forming a second redistribution layer on the first substrate, where the second redistribution layer is electrically connected to the first through silicon vias. The second redistribution layer can alleviate an internal stress of the first through silicon vias.

In a possible implementation, after the bonding a carrier and the first chip, and before the bonding the first chip and the second chip, and forming a first dielectric layer between the first substrate and the first redistribution layer and a plurality of first bonding metal blocks located in the first dielectric layer, the manufacturing method further includes: forming a first insulation barrier layer on a side that is of the first substrate and that is away from the first functional layer. The first insulation barrier layer can protect the first substrate.

In a possible implementation, after the forming first through silicon vias on a first chip from a side of a first functional layer of the first chip, and before the bonding a carrier and the first chip, the manufacturing method further includes: forming a third redistribution layer above the first functional layer, where the third redistribution layer covers the first through silicon vias and is electrically connected to the first through silicon vias. When the third redistribution layer is electrically connected to the first functional layer, the third redistribution layer is formed, so that the first functional layer can be electrically connected to the first through silicon vias.

In a possible implementation, before the forming a first redistribution layer on a second functional layer of a second chip, the manufacturing method further includes: forming second through silicon vias from a side of the second functional layer of the second chip; and after the bonding the first chip and the second chip, and forming a first dielectric layer between the first substrate and the first redistribution layer and a plurality of first bonding metal blocks located in the first dielectric layer, the manufacturing method further includes: forming a fourth redistribution layer on a third functional layer of a third chip, where the third chip includes a third substrate and a third functional layer disposed on the third substrate; and next, bonding the second chip and the third chip, and forming a second dielectric layer between the second substrate and the fourth redistribution layer and a plurality of second bonding metal blocks located in the second dielectric layer, where at least some of the second bonding metal blocks are electrically connected to the second through silicon vias and the fourth redistribution layer respectively. The method for stacking the second chip and the third chip has the same technical effect as the foregoing method for stacking the first chip and the second chip. Refer to the foregoing description. Details are not described herein again. In addition, two or more layers of chips can be stacked by using the chip stacked structure manufacturing method provided in this application.

In a possible implementation, the forming a second dielectric layer between the second substrate and the fourth redistribution layer and a plurality of second bonding metal blocks located in the second dielectric layer includes: forming a third dielectric sub-layer and a plurality of third bonding metal sub-blocks on the second substrate, where the third bonding metal sub-block is disposed in the third dielectric sub-layer, and is exposed on a surface that is of the third dielectric sub-layer and that is away from the second substrate, and at least some of the third bonding metal sub-blocks are electrically connected to the second through silicon vias; and forming a fourth dielectric sub-layer and a plurality of fourth bonding metal sub-blocks on the fourth redistribution layer, where the fourth bonding metal sub-block is disposed in the fourth dielectric sub-layer, and is exposed on a surface that is of the fourth dielectric sub-layer and that is away from the third substrate, and at least some of the fourth bonding metal sub-blocks are electrically connected to the fourth redistribution layer, where the second dielectric layer includes a third dielectric sub-layer and a fourth dielectric sub-layer, and the second bonding metal block includes the third bonding metal sub-block and the fourth bonding metal sub-block. In addition, the second bonding metal block and the second dielectric layer have the same technical effect as the first bonding metal block and the first dielectric layer. Refer to the foregoing description. Details are not described herein again.

In a possible implementation, the third dielectric sub-layer includes a plurality of third hybrid bonding vias in a one-to-one correspondence with the second through silicon vias, and the third bonding metal sub-blocks are electrically connected to the second through silicon vias through the third hybrid bonding vias; and/or the fourth dielectric sub-layer includes a plurality of fourth hybrid bonding vias, and the fourth bonding metal sub-blocks are electrically connected to the fourth redistribution layer through the fourth hybrid bonding vias. The third hybrid bonding via and the fourth hybrid bonding via have the same technical effects as the first hybrid bonding via and the second hybrid bonding via. Refer to the foregoing description. Details are not described herein again.

In a possible implementation, the second through silicon via does not penetrate the second substrate; and after the bonding the first chip and the second chip, and forming a first dielectric layer between the first substrate and the first redistribution layer and a plurality of first bonding metal blocks located in the first dielectric layer, and before the bonding the second chip and the third chip, and forming a second dielectric layer between the second substrate and the fourth redistribution layer and a plurality of second bonding metal blocks located in the second dielectric layer, the manufacturing method further includes: thinning the second substrate from a side that is of the second substrate and that is away from the second functional layer to expose the second through silicon via. The thinning the second substrate to expose the second through silicon via has the same technical effect as the thinning the first substrate to expose the first through silicon via. Refer to the foregoing description. Details are not described herein again.

According to a second aspect, a chip stacked structure is provided. The chip stacked structure includes a first chip and a second chip. The first chip includes a first substrate, a first functional layer disposed on the first substrate, and first through silicon vias that penetrate the first substrate and the first functional layer. When the first through silicon via is manufactured, because the first through silicon via is manufactured from a side of the first functional layer, a diameter of the first through silicon via close to the first functional layer is greater than a diameter of the first through silicon via close to the first substrate. The second chip includes a second substrate and a second functional layer disposed on the second substrate. The first functional layer and the second functional layer each include a functional device, a circuit structure, an interconnection metal wire, a dielectric layer, and the like. The chip stacked structure further includes a first redistribution layer disposed on a side that is of the second functional layer and that is away from the second substrate, a first dielectric layer disposed between the first substrate and the first redistribution layer, and a plurality of first bonding metal blocks disposed in the first dielectric layer. At least some of the first bonding metal blocks are electrically connected to the first through silicon vias and the first redistribution layer respectively. The first chip and the second chip are bonded through the first dielectric layer and the first bonding metal blocks, that is, the first chip and the second chip are bonded in a hybrid bonding (hybrid bonding) manner. The chip stacked structure provided in the second aspect is manufactured by using the chip stacked structure manufacturing method provided in the first aspect. According to the chip stacked structure manufacturing method provided in the first aspect, when the first through silicon via on the first chip is manufactured, the first through silicon via is formed from a side of the first functional layer of the first chip, that is, the first through silicon via is manufactured from the front side of the first chip. Therefore, a diameter of the manufactured first through silicon via close to the first functional layer is greater than a diameter of the first through silicon via close to the first substrate. In addition, according to the chip stacked structure manufacturing method provided in the first aspect, when the first through silicon via is formed, only the dielectric layer and the first substrate that are on the front side of the first chip need to be etched. When two-layer stacking between wafers is implemented through wafer bonding, the process of forming the through silicon via requires etching the dielectric layer in the functional layer on the front side of the chip, as well as etching the substrate and the dielectric layer on the back side of the chip (where the dielectric layer on the back side of the chip may include a flat layer, a hard mask, and the like). By contrast, in embodiments of this application, the process of etching the dielectric layer on the back side of the first chip is reduced in the process of forming the first through silicon via through etching. Therefore, the process of forming the first through silicon via in embodiments of this application is simpler. In addition, in this application, because the first through silicon via is formed from a side of the first functional layer of the first chip, in a process of manufacturing the first through silicon via, the first through silicon via may penetrate the first substrate or stop at any position in the first substrate. When a TSV is manufactured from a side of a silicon substrate of a first wafer, a high requirement is imposed on a depth of the TSV, and the manufactured TSV should be in contact with a circuit structure or an interconnection metal wire in a functional layer. By contrast, in this application, difficulty in manufacturing the first through silicon via can be further reduced.

Based on this, when at least one of the first chip and the second chip is a wafer, in a stacking process of the first chip and the second chip, because a processing capability of the wafer is fine, the first bonding metal blocks formed between the first chip and the second chip may be made small. In this way, a pitch between adjacent first bonding metal blocks is small, and the pitch between adjacent first bonding metal blocks may reach 0.5 µm to 15 µm, or even smaller. In this way, a density of the first bonding metal blocks disposed between the first chip and the second chip increases, so that an interconnection density between the first chip and the second chip can be increased, and an interconnection bandwidth between the first chip and the second chip can be increased. Compared with interconnection between adjacent chips implemented through a micro bump, when interconnection between the first chip and the second chip is implemented through the first bonding metal block, an interconnection density per square millimeter can be increased by more than 10 times, and even more than 1000 times at most.

In addition, when both the first chip and the second chip are wafers, because alignment precision between the wafer and the wafer is high, a size of a first bonding metal block formed between the first chip and the second chip may be further reduced, that is, a pitch between adjacent first bonding metal blocks may be further reduced, thereby further improving the interconnection density between the first chip and the second chip, and further improving the interconnection bandwidth between the first chip and the second chip.

In addition, the first chip and the second chip are directly bonded through the first dielectric layer and the first bonding metal block. Therefore, after the first chip and the second chip are stacked, there is no need to fill a filling material between the first chip and the second chip. In one aspect, the process can be simplified. In another aspect, because the filling material is generally an organic material, a substrate of the first chip and the second chip is generally a silicon substrate, and a difference between thermal expansion coefficients of the organic material and the silicon substrate is large, the filling material causes a stress matching problem. In addition, a material of the first dielectric layer is generally one or more of silicon nitride, silicon oxide, silicon oxynitride, silicon carbide, and the like, and silicon nitride, silicon oxide, silicon oxynitride, and silicon carbide have thermal expansion coefficients close to that of the silicon substrate. Therefore, this application can further avoid the stress matching problem caused by the filling material.

In a possible implementation, the first through silicon via includes an electroplated column and a first conductive barrier layer wrapping a side surface of the electroplated column, and the first conductive barrier layer is not disposed on a surface that is of the electroplated column and that is away from the second chip. In this embodiment of this application, when the first through silicon via is manufactured, the first through silicon via is formed from a side of the first functional layer (where in this case, the first through silicon via is empty and is not filled with a conductive material). When the first conductive barrier layer and the electroplated column are formed from a side of the first functional layer, the first conductive barrier layer is not formed on the top surface of the electroplated column, that is, the surface of the electroplated column away from the second chip.

In a possible implementation, the first conductive barrier layer is not disposed on a surface that is of the electroplated column and that is close to the second chip. In this embodiment of this application, when the first through silicon via is manufactured, the first through silicon via is formed from a side of the first functional layer, and the first through silicon via does not penetrate the first substrate. Subsequently, the first through silicon via is exposed by thinning the first substrate. In this way, because the first conductive barrier layer on the bottom surface of the electroplated column is thinned, for the manufactured first through silicon via, only the side surface of the electroplated column is wrapped with the first conductive barrier layer, and the first conductive barrier layer is not disposed on the upper and lower bottom surfaces (namely, the surface that is of the electroplated column and that is away from the second chip and the surface that is close to the second chip) of the electroplated column. When the first through silicon via is formed by using such a process, the first through silicon via does not penetrate the first substrate, and the first through silicon via is subsequently exposed by thinning the first substrate. Therefore, when the first through silicon via is manufactured, only the dielectric layer on the front side of the first chip and a part of the first substrate need to be etched, thereby further reducing difficulty in manufacturing the first through silicon via.

In a possible implementation, a material of the first conductive barrier layer includes one or more of titanium, titanium nitride, tantalum, or tantalum nitride.

In a possible implementation, the first bonding metal block includes a first bonding metal sub-block and a second bonding metal sub-block that are mutually bonded, the first bonding metal sub-block is close to the first through silicon via, and the second bonding metal sub-block is close to the first redistribution layer. The first bonding metal sub-block may be formed on the first substrate, the second bonding metal sub-block may be formed on the first redistribution layer, and bonding of the first chip and the second chip is implemented by bonding the first bonding metal sub-block and the second bonding metal sub-block.

In a possible implementation, the first dielectric layer includes a first dielectric sub-layer and a second dielectric sub-layer that are mutually bonded, the first dielectric sub-layer is close to the first substrate, and the second dielectric sub-layer is close to the first redistribution layer; and the first bonding metal sub-block is disposed in the first dielectric sub-layer, and is exposed on a surface that is of the first dielectric sub-layer and that is away from the first substrate; and the second bonding metal sub-block is disposed in the second dielectric sub-layer, and is exposed on a surface that is of the second dielectric sub-layer and that is away from the first redistribution layer. When the first bonding metal sub-block and the second bonding metal sub-block are bonded, the first dielectric sub-layer and the second dielectric sub-layer are bonded, so that bonding of the first chip and the second chip can be implemented. In addition, because the first dielectric sub-layer and the second dielectric sub-layer are bonded, after the first chip and the second chip are bonded, there is no need to fill a filling material between the first chip and the second chip. Therefore, the process can be simplified, and the stress matching problem can be avoided.

In a possible implementation, the first dielectric sub-layer includes a plurality of first hybrid bonding vias, and the first bonding metal sub-blocks are electrically connected to the first through silicon vias through the first hybrid bonding vias; and/or the second dielectric sub-layer includes a plurality of second hybrid bonding vias, and the second bonding metal sub-blocks are electrically connected to the first redistribution layer through the second hybrid bonding vias. The first hybrid bonding via and the second hybrid bonding via are disposed to ensure that some first bonding metal sub-blocks are electrically connected to the first through silicon vias, and some second bonding metal sub-blocks are electrically connected to the first redistribution layer, to prevent other first bonding metal sub-blocks and second bonding metal sub-blocks from being electrically connected to the circuit structure. In this way, the plurality of first bonding metal sub-blocks and the plurality of second bonding metal sub-blocks can be evenly distributed when being disposed.

In a possible implementation, the chip stacked structure further includes a second redistribution layer disposed between the first substrate and the first dielectric layer, and the second redistribution layer is electrically connected to the first through silicon vias and the first bonding metal blocks respectively. The second redistribution layer can alleviate an internal stress of the first through silicon vias.

In a possible implementation, a projection of the first bonding metal blocks on the first chip has an overlapping area with the first through silicon vias; or a projection of the first bonding metal blocks on the first chip has no overlapping area with the first through silicon vias. When the projection of the first bonding metal blocks on the first chip has no overlapping area with the first through silicon vias, a stress concentration problem can be avoided.

In a possible implementation, the chip stacked structure further includes a first insulation barrier layer disposed between the first substrate and the first dielectric layer, the first insulation barrier layer includes a plurality of hollow areas, and the first bonding metal blocks are electrically connected to the first through silicon vias through the hollow areas on the first insulation barrier layer. The first insulation barrier layer can be used to protect the first substrate.

In a possible implementation, the chip stacked structure further includes a third redistribution layer disposed on a side that is of the first functional layer and that is away from the first substrate, where the third redistribution layer is electrically connected to the first through silicon vias. When the third redistribution layer is electrically connected to the first functional layer, the third redistribution layer is disposed, so that the first functional layer can be electrically connected to the first through silicon vias.

In a possible implementation, the second chip further includes second through silicon vias that penetrate the second substrate and the second functional layer, the second through silicon vias are electrically connected to the first redistribution layer, and a diameter of the second through silicon via close to the second functional layer is greater than a diameter of the second through silicon via close to the second substrate. The chip stacked structure further includes a third chip, where the third chip includes a third substrate and a third functional layer disposed on the third substrate. The chip stacked structure further includes a fourth redistribution layer disposed on a side that is of the third functional layer and that is away from the third substrate, and a second dielectric layer disposed between the second substrate and the fourth redistribution layer and a plurality of second bonding metal blocks disposed in the second dielectric layer, where at least some of the second bonding metal blocks are electrically connected to the second through silicon vias and the fourth redistribution layer respectively. The second through silicon via has the same technical effect as the first through silicon via. Refer to the foregoing first through silicon via. Details are not described herein again. In addition, the bonding of the second chip and the third chip has the same technical effect as the bonding of the first chip and the second chip. Refer to the foregoing description. Details are not described herein again. In addition, this application can implement stacking of two or more layers of chips.

In a possible implementation, the second bonding metal block includes a third bonding metal sub-block and a fourth bonding metal sub-block that are mutually bonded, the third bonding metal sub-block is close to the second through silicon via, and the fourth bonding metal sub-block is close to the fourth redistribution layer. The second bonding metal block has the same technical effect as the first bonding metal block. Refer to the foregoing description. Details are not described herein again.

In a possible implementation, the second dielectric layer includes a third dielectric sub-layer and a fourth dielectric sub-layer that are disposed in a stacked manner, the third dielectric sub-layer is close to the second substrate, and the fourth dielectric sub-layer is close to the fourth redistribution layer; and the third bonding metal sub-block is disposed in the third dielectric sub-layer, and is exposed on a surface that is of the third dielectric sub-layer and that is away from the second substrate; and the fourth bonding metal sub-block is disposed in the fourth dielectric sub-layer, and is exposed on a surface that is of the fourth dielectric sub-layer and that is away from the fourth redistribution layer. The second dielectric layer has the same technical effect as the foregoing first dielectric layer. Refer to the foregoing description. Details are not described herein again.

In a possible implementation, the third dielectric sub-layer includes a plurality of third hybrid bonding vias in a one-to-one correspondence with the second through silicon vias, and the third bonding metal sub-blocks are electrically connected to the second through silicon vias through the third hybrid bonding vias; and/or the fourth dielectric sub-layer includes a plurality of fourth hybrid bonding vias, and the fourth bonding metal sub-blocks are electrically connected to the fourth redistribution layer through the fourth hybrid bonding vias. The third hybrid bonding via and the fourth hybrid bonding via have the same technical effects as the first hybrid bonding via and the second hybrid bonding via. Refer to the foregoing description. Details are not described herein again.

In a possible implementation, a projection of the second through silicon vias on the first chip has an overlapping area with the first through silicon vias; or a projection of the second through silicon vias on the first chip has no overlapping area with the first through silicon vias. When the projection of the second through silicon vias on the first chip has no overlapping area with the first through silicon vias, stress concentration can be reduced.

According to a third aspect, a chip stacked structure is provided, where the chip stacked structure includes a first chip and a second chip. The first chip includes a first substrate, a first functional layer disposed on the first substrate, and first through silicon vias that penetrate the first substrate and the first functional layer. The second chip includes a second substrate and a second functional layer disposed on the second substrate. The chip stacked structure further includes a first redistribution layer disposed on a side that is of the second functional layer and that is away from the second substrate, a first dielectric layer disposed between the first substrate and the first redistribution layer, and a plurality of first bonding metal blocks disposed in the first dielectric layer. At least some of the first bonding metal blocks are electrically connected to the first through silicon vias and the first redistribution layer respectively. The first chip and the second chip are bonded through the first dielectric layer and the first bonding metal blocks, the first through silicon via includes an electroplated column and a first conductive barrier layer wrapping a side surface of the electroplated column, and the first conductive barrier layer is not disposed on a surface that is of the electroplated column and that is away from the second chip. Refer to related descriptions of the first aspect. Details are not described herein again.

In a possible implementation, the first conductive barrier layer is not disposed on a surface that is of the electroplated column and that is close to the second chip. Refer to related descriptions of the first aspect. Details are not described herein again.

In a possible implementation, a material of the first conductive barrier layer includes one or more of titanium, titanium nitride, tantalum, or tantalum nitride.

In a possible implementation, a diameter of the first through silicon via close to the first functional layer is greater than or equal to a diameter of the first through silicon via close to the first substrate.

According to a fourth aspect, a chip package structure is provided, where the chip package structure includes a package substrate and the chip stacked structure provided in the second aspect or the third aspect; and the chip stacked structure is electrically connected to the package substrate. The chip package structure has the same technical effect as the chip stacked structure provided in the second aspect or the third aspect. Refer to the foregoing description. Details are not described herein again.

According to a fifth aspect, an electronic device is provided, where the electronic device includes a printed circuit board and the chip package structure provided in the fourth aspect, and the chip package structure is electrically connected to the printed circuit board. The electronic device has the same technical effect as the chip stacked structure provided in the second aspect or the third aspect. Refer to the foregoing description. Details are not described herein again.

### BRIEF DESCRIPTION OF DRAWINGS

FIG. 1 is a schematic structural diagram of a chip stacked structure according to a current technology;
FIG. 2 is a schematic structural diagram of an electronic device according to an embodiment of this application;
FIG. 3 is a schematic structural diagram of a chip stacked structure according to an embodiment of this application;
FIG. 4a is a schematic structural diagram of a chip stacked structure according to another embodiment of this application;
FIG. 4b is a schematic flowchart of a chip stacked structure manufacturing method according to an embodiment of this application;
FIG. 5 is a schematic structural diagram 1 of a process of manufacturing a chip stacked structure according to an embodiment of this application;
FIG. 6 is a schematic structural diagram 2 of a process of manufacturing a chip stacked structure according to an embodiment of this application;
FIG. 7 is a schematic structural diagram 3 of a process of manufacturing a chip stacked structure according to an embodiment of this application;
FIG. 8a is a schematic structural diagram 4 of a process of manufacturing a chip stacked structure according to an embodiment of this application;
FIG. 8b is a schematic structural diagram 5 of a process of manufacturing a chip stacked structure according to an embodiment of this application;
FIG. 8c is a schematic structural diagram 6 of a process of manufacturing a chip stacked structure according to an embodiment of this application;
FIG. 8d is a schematic structural diagram 7 of a process of manufacturing a chip stacked structure according to an embodiment of this application;
FIG. 9 is a schematic structural diagram 8 of a process of manufacturing a chip stacked structure according to an embodiment of this application;
FIG. 10a is a schematic structural diagram 9 of a process of manufacturing a chip stacked structure according to an embodiment of this application;
FIG. 10b is a schematic structural diagram 10 of a process of manufacturing a chip stacked structure according to an embodiment of this application;
FIG. 11 is a schematic structural diagram 11 of a process of manufacturing a chip stacked structure according to an embodiment of this application;
FIG. 12 is a schematic structural diagram 12 of a process of manufacturing a chip stacked structure according to an embodiment of this application;
FIG. 13 is a schematic structural diagram 13 of a process of manufacturing a chip stacked structure according to an embodiment of this application;
FIG. 14a is a schematic structural diagram 14 of a process of manufacturing a chip stacked structure according to an embodiment of this application;
FIG. 14b is a schematic structural diagram 15 of a process of manufacturing a chip stacked structure according to an embodiment of this application;
FIG. 15a is a schematic structural diagram 16 of a process of manufacturing a chip stacked structure according to an embodiment of this application;
FIG. 15b is a schematic structural diagram 17 of a process of manufacturing a chip stacked structure according to an embodiment of this application;
FIG. 16 is a schematic structural diagram 18 of a process of manufacturing a chip stacked structure according to an embodiment of this application;
FIG. 17 is a schematic structural diagram 19 of a process of manufacturing a chip stacked structure according to an embodiment of this application;
FIG. 18 is a schematic structural diagram 20 of a process of manufacturing a chip stacked structure according to an embodiment of this application;
FIG. 19 is a schematic structural diagram 21 of a process of manufacturing a chip stacked structure according to an embodiment of this application;
FIG. 20 is a schematic structural diagram 22 of a process of manufacturing a chip stacked structure according to an embodiment of this application;
FIG. 21 is a schematic structural diagram 23 of a process of manufacturing a chip stacked structure according to an embodiment of this application;
FIG. 22 is a schematic structural diagram 24 of a process of manufacturing a chip stacked structure according to an embodiment of this application;
FIG. 23 is a schematic structural diagram 25 of a process of manufacturing a chip stacked structure according to an embodiment of this application;
FIG. 24 is a schematic structural diagram 26 of a process of manufacturing a chip stacked structure according to an embodiment of this application;
FIG. 25 is a schematic structural diagram 27 of a process of manufacturing a chip stacked structure according to an embodiment of this application;
FIG. 26 is a schematic structural diagram 28 of a process of manufacturing a chip stacked structure according to an embodiment of this application;
FIG. 27 is a schematic structural diagram 29 of a process of manufacturing a chip stacked structure according to an embodiment of this application;
FIG. 28 is a schematic structural diagram 30 of a process of manufacturing a chip stacked structure according to an embodiment of this application;
FIG. 29 is a schematic structural diagram of a chip stacked structure according to still another embodiment of this application;
FIG. 30 is a schematic structural diagram of a chip stacked structure according to still another embodiment of this application; and
FIG. 31 is a schematic structural diagram of a chip stacked structure according to still another embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The following terms "first", "second" and the like are merely intended for ease of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In embodiments of this application, unless otherwise specified and limited, the term "electrical connection" may be a direct electrical connection, or may be an indirect electrical connection through an intermediate dielectric.

In addition, in embodiments of this application, the word "exemplary" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the word "example", "for example" or the like is intended to present a relative concept in a specific manner.

In embodiments of this application, the term "and/or" describes an association relationship between associated objects and may indicate three relationships. For example, A and/or B may indicate the following cases: Only A exists, both A and B exist, and only B exists, where A and B may be singular or plural. The character "/" generally indicates an "or" relationship between the associated objects.

In embodiments of this application, for example, "upper", "lower", "left", "right", "front", and "rear" are used to explain that structures and motion directions of different components in this application are relative. These indications are appropriate when the components are in positions shown in the figure. However, if descriptions of the positions of the components change, these direction indications change accordingly.

An embodiment of this application provides an electronic device. The electronic device may include electronic products such as an image sensor, a NAND flash memory, a high-bandwidth memory, a mobile phone (mobile phone), a tablet computer (pad), a television, an intelligent wearable product (for example, a smartwatch or a smart band), a virtual reality (virtual reality, VR) terminal device, and an augmented reality (augmented reality, AR) terminal device. A specific form of the electronic device is not specifically limited in this embodiment of this application.

As shown in FIG. 2, the electronic device 01 includes a printed circuit board (printed circuit board, PCB), a chip package structure 1, and a first connecting member 2 disposed between the PCB and the chip package structure 1. The chip package structure 1 is electrically connected to the PCB through the first connecting member 2. The first connecting member 2 may be, for example, a ball grid array (ball grid array, BGA).

Still refer to FIG. 2. The chip package structure 1 includes a chip stacked structure 10, a package substrate (substrate) 20, and a second connecting member 30 disposed between the chip stacked structure 10 and the package substrate 20. The chip stacked structure 10 is electrically connected to the package substrate 20 through the second connecting member 30. The second connecting member 30 may be, for example, a controlled collapse chip connection bump (controlled collapse chip connection bump, C4 bump).

It should be understood that the chip package structure 1 is electrically connected to the PCB through the first connecting member 2, that is, the package substrate 20 in the chip package structure 1 is electrically connected to the PCB through the first connecting member 2. Because the chip stacked structure 10 is electrically connected to the package substrate 20 through the second connecting member 30, and the package substrate 20 is electrically connected to the PCB through the first connecting member 2, communication between the chip stacked structure 10 and the electronic system can be implemented.

The chip stacked structure 10 includes a plurality of chips 100 that are sequentially stacked. It may be understood that, the plurality of chips 100 are stacked sequentially, which has many advantages compared with the plurality of chips being disposed separately. For example, a higher bandwidth can be obtained, to obtain a higher storage or computing density. A package size can be further reduced, and an integration level of a chip can be improved. Therefore, the chip stacked structure 10 has high-value applications.

It should be understood that, in the chip stacked structure 10, each chip 100 includes a substrate and a functional layer disposed on the substrate. In a working process, the functional layer may enable the chip to implement a function of the chip, for example, a logical computing function or a storage function. The functional layer mainly includes a functional device, a circuit structure, an interconnection metal wire, a dielectric layer, and the like.

In addition, a material of the substrate of the chip 100 may include, for example, one or more of silicon

(Si), germanium (Ge), gallium nitride (GaN), gallium arsenide (GaAs), or another semiconductor material. In addition, the material of the substrate may be, for example, glass (glass) or an organic material.

It should be noted that, in this embodiment of this application, the chip 100 in the chip stacked structure 10 may be a wafer (wafer) with a functional layer formed, or may be a bare chip (die) obtained by cutting a wafer with a functional layer formed. The bare chip may also be referred to as a grain or a particle. In some scenarios, the chip may also be a packaged chip obtained by packaging the bare chip. Based on this, in some embodiments, the plurality of chips 100 in the chip stacked structure 10 may all be bare chips or chips obtained by packaging the bare chips. In some other embodiments, the plurality of chips 100 in the chip stacked structure 10 may all be wafers. In some other embodiments, in the plurality of chips 100 in the chip stacked structure 10, some chips may be wafers, and some chips may be bare chips and/or chips obtained by packaging the bare chips.

In the foregoing chip stacked structure 10, to implement interconnection between adjacent chips 100, the following provides two optional implementations for the chip stacked structure 10. The first optional implementation is mainly used for two-layer stacking between wafers, and the second optional implementation is mainly used for multi-layer stacking of bare chips or multi-layer stacking between a bare chip and a wafer.

In the first optional implementation, two-layer stacking between wafers is implemented by using a wafer bonding technology. Specifically, as shown in FIG. 1, a first wafer and a second wafer are bonded through a dielectric layer, and the first wafer and the second wafer are interconnected to the outside through TSVs. Refer to FIG. 1. The first wafer and the second wafer each include a silicon substrate and a functional layer disposed on the silicon substrate. The functional layer includes a functional device, a circuit structure, an interconnection metal wire, a dielectric layer, and the like. When the first wafer and the second wafer are stacked by using the wafer bonding technology, the first wafer and the second wafer are first bonded through the dielectric layer, and the functional layer of the first wafer is close to the functional layer of the second wafer. The TSV is then manufactured from a side of the silicon substrate of the first wafer. To prevent the silicon substrate of the first wafer from being polluted during etching of the TSV, a dielectric layer is formed on the silicon substrate of the first wafer. The dielectric layer may include a flat layer, a hard mask, and the like. In this way, when the TSV is manufactured from the side of the silicon substrate of the first wafer, at least the dielectric layer on the silicon substrate of the first wafer, the silicon substrate of the first wafer, and the dielectric layer in the functional layer of the first wafer need to be etched in an etching process. In other words, at least the dielectric layer, the silicon substrate, and the dielectric layer need to be etched sequentially during manufacturing of the TSV. This increases difficulty in etching of the TSV. In addition, when the TSV is manufactured from the side of the silicon substrate of the first wafer, the process of manufacturing the TSV has a high requirement on a depth of the TSV, and the manufactured TSV should be in contact with the circuit structure or the interconnection metal wire in the functional layer, to implement an electrical connection between the TSV and the circuit structure. In this way, difficulty in etching the TSV is further increased, and there is a large technical challenge to the process.

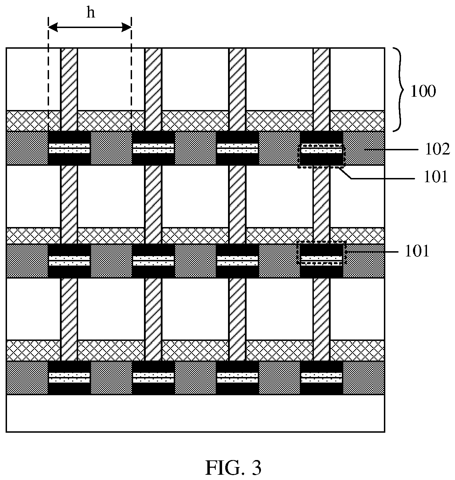

In the second optional implementation, as shown in FIG. 3, micro bumps (micro bumps) 101 are respectively disposed on two adjacent chips 100, physical and electrical interconnection between the two adjacent chips 100 is implemented through the micro bumps 101, and a filling material 102 is filled between the two adjacent chips 100. However, the micro bump technology is mainly used for multi-layer stacking between bare chips or multi-layer stacking of a bare chip and a wafer, and alignment precision between bare chips and between a bare chip and a wafer is poor. Moreover, due to a limitation of a process of manufacturing a micro bump on a bare chip, a size of the micro bump 101 is generally large. As a result, a pitch between adjacent micro bumps 101 is large. As shown in FIG. 3, a pitch h between adjacent micro bumps 101 manufactured by using the micro bump technology is approximately 55 µm, that is, one micro bump 101 may be placed in a range of 55 µm*55 µm. In this way, an interconnection density between stacked chips 100 is low, and consequently, an interconnection bandwidth between the chips is low. In addition, the filling material 102 filled between two adjacent chips 100 is generally an organic material, and a substrate of a chip is generally a silicon substrate. A difference between thermal expansion coefficients of the organic material and the silicon substrate is large. Therefore, the filling material further causes a stress matching problem.

To resolve the high difficulty in etching the through silicon via in the chip stacked structure 10 manufactured by using the foregoing two optional implementations, the low interconnection density between adjacent chips, and the stress matching problem caused by the filling material, an embodiment of this application further provides a chip stacked structure 10 and a manufacturing method thereof. The chip stacked structure 10 may be used in the foregoing chip package structure 1.

The following describes, by using an example, a specific structure and a manufacturing method of the chip stacked structure 10 provided in this embodiment of this application.

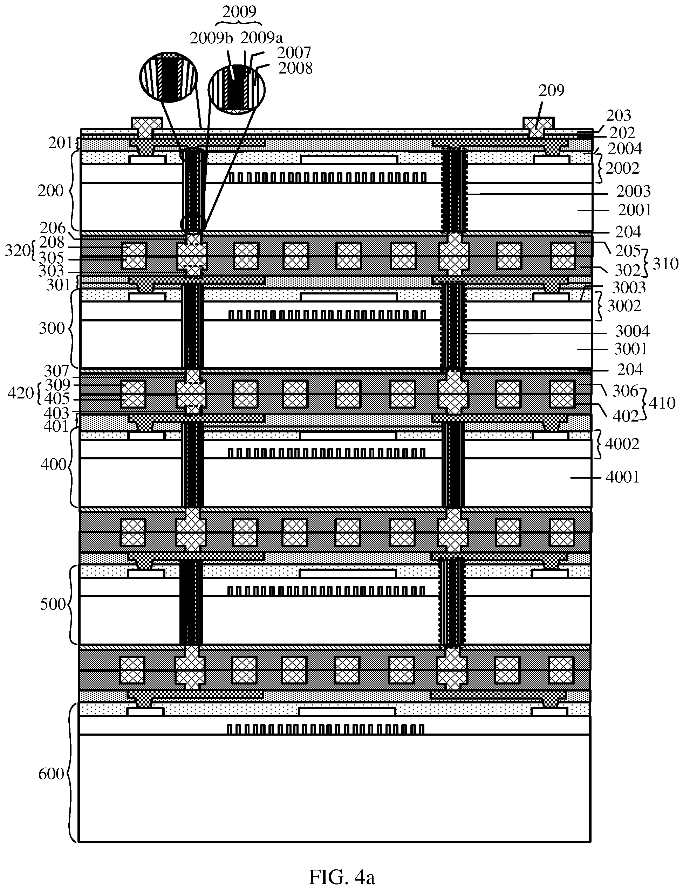

As shown in FIG. 4a, the chip stacked structure 10 includes a plurality of chips that are sequentially stacked. A quantity of chips in the chip stacked structure 10 is not limited in this embodiment of this application, and the chips may be stacked as required. For example, the chip stacked structure 10 may include two chips that are sequentially stacked, for example, a first chip 200 and a second chip 300, or may include three chips that are sequentially stacked, for example, a first chip 200, a second chip 300, and a third chip 400. It may be understood that the chip stacked structure 10 includes but is not limited to two or three chips that are stacked sequentially, and more chips may be stacked. FIG. 4a is illustrated by using an example in which the chip stacked structure 10 includes five sequentially stacked chips, which are respectively a first chip 200, a second chip 300, a third chip 400, a fourth chip 500, and a fifth chip 600.

Types of the plurality of chips 100 in the chip stacked structure 10 are not limited. Any chip 100 may be, for example, a storage chip, a logic (logic) chip, or a chip with any other function. The storage chip may be, for example, a dynamic random access memory (dynamic random access memory, DRAM) chip. In addition, the plurality of chips 100 in the chip stacked structure 10 may be chips of a same type, for example, all the chips are storage chips; or may be chips of different types. For example, the chip stacked structure 10 includes a storage chip and a logic chip. Based on this, the chip stacked structure 10 provided in this embodiment of this application can implement integration between chips of a same type or different types.

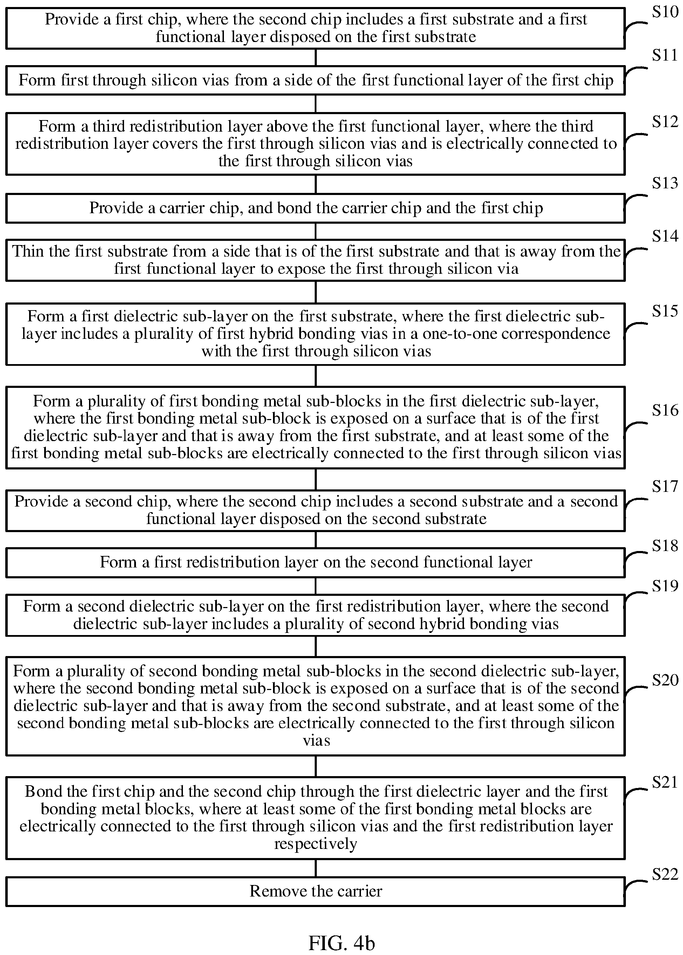

The following describes a method for manufacturing the chip stacked structure 10 by using an example in which the chip stacked structure 10 includes a first chip 200 and a second chip 300 that are sequentially stacked. As shown in FIG. 4b, the method for manufacturing the chip stacked structure 10 specifically includes the following steps.

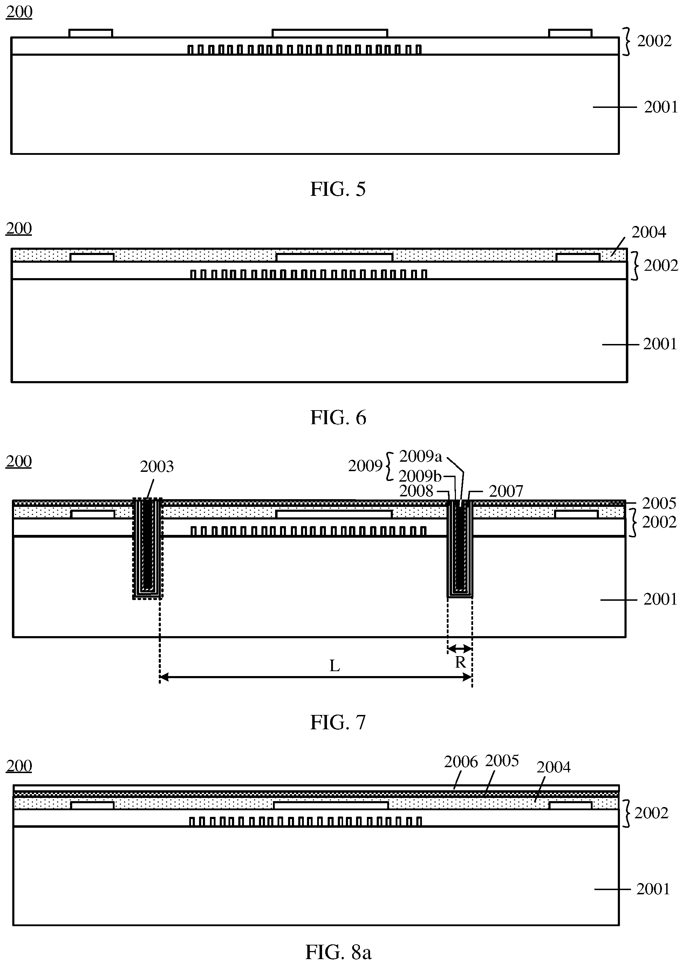

S10: As shown in FIG. 5, provide a first chip 200, where the first chip 200 includes a first substrate 2001 and a first functional layer 2002 disposed on the first substrate 2001.

The first functional layer 2002 includes a functional device, a circuit structure, an interconnection metal wire, a dielectric layer, and the like. In other words, the first chip 200 provided in step S10 is a chip that has complete functions and completes a front-end device, a circuit structure, and a back-end metal interconnection process. In addition, the first chip 200 may be a wafer or a bare chip.

It should be noted that, to facilitate manufacturing of another film layer on the first functional layer 2002 of the first chip 200, in some examples, before the manufacturing of the another film layer on the first functional layer 2002, the method for manufacturing the chip stacked structure 10 (namely, step S10) further includes: as shown in FIG. 6, a first flat layer 2004 is formed on the first functional layer 2002 of the first chip 200, to perform flatness processing on a surface of the first chip 200.

S11: As shown in FIG. 7, form first through silicon vias 2003 from a side of the first functional layer 2002 of the first chip 200, that is, manufacture the first through silicon vias 2003 from a front side of the first chip 200.

Because the first through silicon via 2003 is formed after the first chip 200 completes the front-end device, the circuit structure, and the back-end metal interconnection, the first through silicon via 2003 may also be referred to as a TSV via last (where the through silicon via is formed after the device and the metal wire are manufactured).

It should be noted that the first through silicon via 2003 passes through different layers including the first substrate 2001. For the first substrate 2001, the first through silicon via may penetrate the first substrate 2001, or may not penetrate the first substrate 2001. In addition, it should be understood that the first through silicon vias 2003 are not limited to being completely formed in the first substrate 2001, and may also be partially formed in another layer such as the first functional layer 2002.

In some examples, as shown in FIG. 7, a diameter R of the first through silicon via 2003 may range from 0.5 µm to 15 µm. For example, the diameter R of the first through silicon via 2003 may be 0.5 µm, 3 µm, 7 µm, 10 µm, 15 µm, or the like.

In some examples, as shown in FIG. 7, a pitch (pitch) L between adjacent first through silicon vias 2003 is 1 µm to 30 µm. For example, the pitch L between adjacent first through silicon vias 2003 is 1 µm, 5 µm, 13 µm, 18 µm, 30 µm, or the like.

For example, step S11 may be implemented through the following steps.

S110: As shown in FIG. 8a, deposit a hard mask (hard mask, HM) 2005 and coat a photoresist thin film 2006 on the first flat layer 2004 sequentially.

It should be noted that, depositing the hard mask 2005 in step S110 is an optional step. In some examples, in step S110, only the photoresist thin film 2006 may be coated, and the hard mask 2005 is not deposited. Considering that when the first through silicon via 2003 is etched, the depth of the first through silicon via 2003 is generally large, the etching depth is large and the etching time is long. In this way, the photoresist thin film 2006 may be etched off, and therefore, a place that does not need to be etched cannot be protected. Based on this, in some examples, the hard mask 2005 is deposited and the photoresist thin film 2006 is coated sequentially. When the first through silicon via 2003 is etched, the hard mask 2005 may be used to protect a place that does not need to be etched.

The hard mask thin film may be deposited by using methods such as physical vapor deposition, chemical vapor deposition, and sputtering (sputter), for example, magnetron sputtering.

In addition, a material of the hard mask 2005 may be, for example, one or more of silicon nitride (SiNx), silicon oxide (SiOx), silicon oxynitride (SiOxNy), or silicon carbide (SiCx). A material of the photoresist thin film 2006 may be, for example, an organic material. In addition, the material of the photoresist thin film 2006 may be a positive photoresist, or may be a negative photoresist.

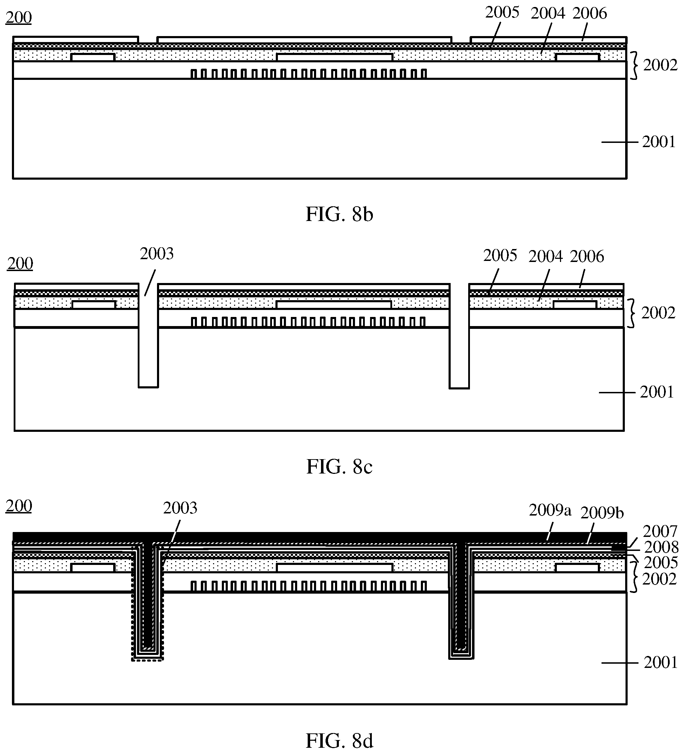

S111: As shown in FIG. 8b, perform mask exposure and development on the photoresist thin film 2006, to form a plurality of hollow areas.

S112: As shown in FIG. 8c, form first through silicon vias 2003 through etching. A process of forming the first through silicon vias 2003 through etching includes etching the hard mask 2005, the first flat layer 2004, the dielectric layer manufactured through a front end of line (front end of line, FEOL) process and a backend of line (backend of line, BEOL) process in the first functional layer 200, the first substrate 2001, and the like that face the hollow areas of the photoresist thin film 2006.

It should be noted that the first through silicon via 2003 formed in step S 112 is empty, and is not filled with a conductive material.

In addition, in the etching process, the first through silicon via 2003 may penetrate the first substrate 2001, or may not penetrate the first substrate 2001. Because the first substrate 2001 is thick, penetrating the first substrate 2001 increases process difficulty. To reduce the process difficulty in manufacturing the first through silicon via 2003, in some examples, the first through silicon via 2003 does not penetrate the first substrate 2001. FIG. 8c is illustrated by using an example in which the first through silicon via 2003 does not penetrate the first substrate 2001.

It may be understood that, after the first through silicon via 2003 is formed through etching, step S 112 further includes removing the photoresist thin film 2006.

S113: As shown in FIG. 8d, deposit a first insulation layer 2008, a first conductive barrier layer (barrier) 2007, and an electroplated seed layer (seed) 2009b sequentially, and electroplate the conductive layer 2009a by using an electroplating process, for example, electroplate copper (Cu).

The first insulation layer 2008 may be deposited by using a method such as atomic layer deposition (atomic layer deposition, ALD) or chemical vapor deposition (chemical vapor deposition, CVD). The first conductive barrier layer 2007 and the electroplated seed layer 2009b may be deposited by using a method such as physical vapor deposition, chemical vapor deposition, or sputtering, for example, magnetron sputtering.

Based on this, a material of the first insulation layer 2008 may be, for example, silicon oxide, silicon nitride, or silicon oxynitride. Materials of the electroplated seed layer 2009b and the conductive layer 2009a may include, for example, one or more of titanium (Ti), copper (Cu), nickel (Ni), cobalt (Co), wolfram (W), or a related alloy. A material of the first conductive barrier layer 2007 may include, for example, Ti, titanium nitride (TiN), tantalum (Ta), and tantalum nitride (TaN).

It may be understood that, when the material of the first substrate 2001 is a semiconductor material, a function of the first insulation layer 2008 is to perform electrical isolation between the first substrate 2001 and the first conductive barrier layer 2007. The first conductive barrier layer 2007 is deposited to prevent the metal in the electroplated seed layer 2009b and the electroplated conductive layer 2009a from spreading to the first substrate 2001 or another film layer, which affects performance of the first substrate 2001 or the another film layer. In addition, the first conductive barrier layer 2007 may further play an adhesive role. The electroplated seed layer 2009b is deposited so that the conductive layer 2009a can be electroplated on the electroplated seed layer 2009b by using an electroplating process.

In some examples, after the conductive layer 2009a is electroplated, step S113 further includes a process such as thermal annealing.

S114: Remove, by using a chemical mechanical polishing (chemical mechanical polishing, CMP) process, the first insulation layer 2008, the first conductive barrier layer 2007, the electroplated seed layer 2009b, and the conductive layer 2009a that are outside the first through silicon via 2003, to form the first through silicon via 2003 shown in FIG. 7. The first through silicon via 2003 formed in this case includes the electroplated column 2009, the first conductive barrier layer 2007 that wraps a side surface and a bottom surface of the electroplated column 2009 sequentially, and the first insulation layer 2008, where the electroplated column 2009 includes the conductive column 2009a formed by using the electroplating process and the electroplated seed layer 2009b that wraps the side surface and the bottom surface of the conductive column 2009a. It may be understood that the first conductive barrier layer 2007 and the first insulation layer 2008 are not formed on the top surface of the electroplated column 2009, and the electroplated seed layer 2009b is not formed on the top surface of the conductive column 2009a.

Based on the foregoing description, the first through silicon via 2003 may be formed by performing steps S110 to S114.

In some examples, after step S11, the chip stacked structure 10 further includes a second insulation barrier layer formed above the first functional layer 2002, where the second insulation barrier layer can prevent the metal in the first through silicon via 2003 from spreading outwards. The second insulation barrier layer is not shown in FIG. 7. A material of the second insulation barrier layer may be, for example, one or more of silicon nitride, silicon oxide, silicon oxynitride, or silicon carbide.

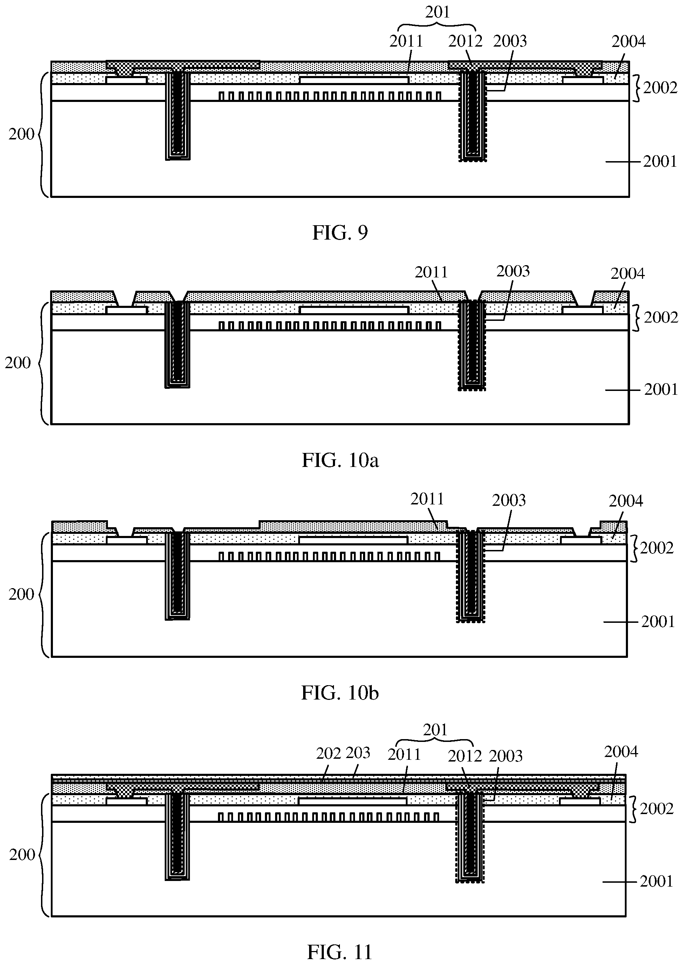

S12: As shown in FIG. 9, form a third redistribution layer (redistribution layer, RDL) 201 above the first functional layer 2002, where the third redistribution layer 201 covers the first through silicon vias 2003 and is electrically connected to the first through silicon vias 2003.

Because the hard mask 2005 may be removed in step S 112 and/or step S114, the hard mask 2005 is shown in FIG. 7, FIG. 8a, FIG. 8b, FIG. 8c, and FIG. 8d, and the hard mask 2005 is not shown in FIG. 9.

It should be noted that step S12 is an optional step, and in some examples, step S12 may alternatively be omitted.

It may be understood that the third redistribution layer 201 includes at least one layer of metal wiring structure and an insulation layer used to space adjacent layers of metal wiring structures, and the adjacent layers of metal wiring structures are electrically connected through vias on the insulation layer. A material of the metal wiring structure may include, for example, one or more conductive materials of copper, aluminum, nickel, gold, silver, titanium, cobalt, and wolfram. A material of the insulation layer may include, for example, one or more of silicon oxide, silicon nitride, silicon oxynitride, silicon carbide, silicone, and polyimide.

It may be understood that the third redistribution layer 201 is electrically connected to the first through silicon vias 2003, that is, the metal wiring structure in the third redistribution layer 201 is electrically connected to the first through silicon vias 2003.

The third redistribution layer 201 may be electrically connected to the first functional layer 2002 of the first chip 200, or may not be electrically connected to the first functional layer 2002. FIG. 9 is illustrated by using an example in which the third redistribution layer 201 is electrically connected to the first functional layer 2002 of the first chip 200.

In addition, a function of disposing the third redistribution layer 201 is to implement an electrical connection between the first functional layer 2002 and the first through silicon vias 2003 when the third redistribution layer 201 is electrically connected to the first functional layer 2002.

For example, the third redistribution layer 201 may be formed by using a Damascus process, and the Damascus process includes a single Damascus process and a double Damascus process. The following describes step S12 by using the double Damascus process as an example. Step S12 may include the following steps.

S120: As shown in FIG. 10a, form a second insulation layer 2011, where the second insulation layer 2011 includes a plurality of vias.

The forming a second insulation layer 2011 specifically includes: depositing an insulation thin film; coating a photoresist thin film, and performing mask exposure and development on the photoresist thin film to form a plurality of hollow areas; etching the insulation thin film directly facing the hollow areas to form the second insulation layer 2011 including the plurality of vias; and removing the photoresist thin film.

S121: As shown in FIG. 10b, etch the second insulation layer 2011 to form a plurality of trenches (trenches).

In some examples, after step S 120 and before step S121, step S12 further includes filling the vias of the second insulation layer 2011 with organic matter. The filling of the organic matter can prevent another layer from being etched when the trenches are formed in step S121, to protect the another layer. In step S121, while the second insulation layer 2011 is etched to form the trenches, the organic matter is also etched off.

The etching the second insulation layer 2011 to form a plurality of trenches specifically includes: coating a photoresist thin film, and performing mask exposure and development on the photoresist thin film to form a plurality of hollow areas; etching the second insulation layer 2011 directly facing the hollow areas to form a plurality of trenches; removing the photoresist thin film; and cleaning.

S122: Sequentially deposit the second conductive barrier layer and the electroplated seed layer, and electroplate the conductive layer by using an electroplating process; and then remove, by using a chemical mechanical polishing process, the second conductive barrier layer, the electroplated seed layer, and the conductive layer that are outside the vias of the second insulation layer 2011 and the trenches of the second insulation layer 2011, where the second conductive barrier layer, the electroplated seed layer, and the conductive layer form a metal wiring structure 2012 in the third redistribution layer 201 shown in FIG. 9. The second conductive barrier layer, the electroplated seed layer, and the conductive layer are not shown in the metal wiring structure 2012 in FIG. 9. Refer to structures of the first conductive barrier layer 2007, the electroplated seed layer 2009b, and the conductive column 2009a in the first through silicon via 2003 in FIG. 7.

For a function of the second conductive barrier layer, refer to the function of the first conductive barrier layer 2007. Details are not described herein again.

For step S122, refer to step S113 and step S114. Details are not described herein again.

It should be noted that step S 120 to step S122 describe a process of manufacturing one layer of metal wiring structure 2012 in the third redistribution layer 201. When the third redistribution layer 201 includes a plurality of layers of redistribution structures 2012, step S 120 to step S122 are repeatedly performed.

In some examples, after step S12, the method for manufacturing the chip stacked structure 10 further includes: as shown in FIG. 11, deposit a third insulation barrier layer 202 above the third redistribution layer 201. For a material of the third insulation barrier layer 202, refer to the material of the second insulation barrier layer. Details are not described herein again.

Based on this, in some examples, after step S12, the method for manufacturing the chip stacked structure 10 further includes: performing flatness processing on the interface formed after step S12, that is, as shown in FIG. 11, depositing a second flat layer 203 above the third redistribution layer 201, and performing chemical mechanical polishing on the second flat layer 203. It should be noted that, when the method for manufacturing the chip stacked structure 10 includes depositing the third insulation barrier layer 202, flatness processing is performed on an interface that forms the third insulation barrier layer 202, that is, the second flat layer 203 is deposited above the third insulation barrier layer 202, and chemical mechanical polishing is performed on the second flat layer 203.

A material of the second flat layer 203 may be, for example, silicon oxide, silicon nitride, or silicon oxynitride.

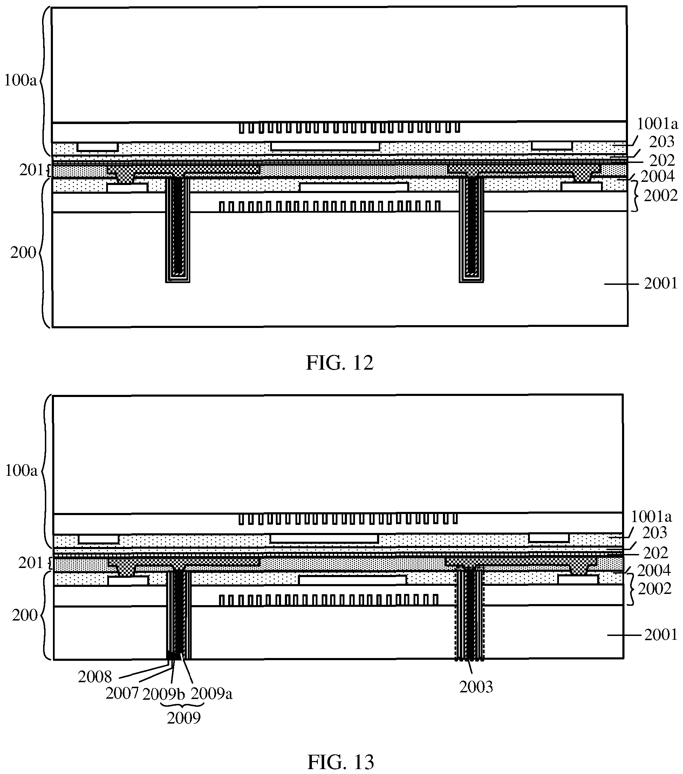

S13: As shown in FIG. 12, provide a carrier (carrier) 100a, and bond the carrier 100a and the first chip 200, where the first functional layer 2002 is close to the carrier 100a relative to the first substrate 2001.

To bond the carrier 100a and the first chip 200, it may be understood that a bonding layer 1001a is formed on a surface that is of the carrier 100a and that is close to the first chip 200. The bonding layer 1001a formed on the surface that is of the carrier 100a and that is close to the first chip 200 may be bonded with a bonding layer on a surface that is of the first chip 200 and that is close to the carrier 100a, to implement bonding between the carrier 100a and the first chip 200. For example, both the second flat layer 203 and the third insulation barrier layer 202 may be used as the bonding layer on the surface that is of the first chip 200 and that is close to the carrier 100a. The bonding layer 1001a formed on the surface that is of the carrier 100a and that is close to the first chip 200 may be bonded with the bonding layer on the surface that is of the first chip 200 and that is close to the carrier 100a in a fusion bonding (fusion bonding) manner or an adhesive bonding (adhesive bonding) manner.

In some examples, the carrier 100a is a carrier chip. In addition, when the carrier 100a is a carrier chip, the bonding layer 1001a may be formed on a side of a substrate of the carrier chip. In this case, the carrier chip and the first chip 200 are bonded back to back. Alternatively, the bonding layer 1001a may be formed on a side of a functional layer of the carrier chip. In this case, the carrier chip and the first chip 200 are bonded face to face. FIG. 12 is illustrated by using an example in which the carrier 100a is a carrier chip, and the carrier chip and the first chip 200 are bonded face to face.

S14: As shown in FIG. 13, thin the first substrate 2001 from a side that is of the first substrate 2001 and that is away from the first functional layer 2003 to expose the first through silicon via 2003. Step S14 may also be referred to as a TSV reveal (TSV reveal) process.

It should be noted that step S14 is an optional step. In some examples, when the first through silicon via 2003 formed in step S11 penetrates the first substrate 2001, step S14 may be omitted. When the first through silicon via 2003 formed in step S11 does not penetrate the first substrate 2001, step S14 needs to be performed.

The first substrate 2001 may be thinned in at least one manner of physical thinning, dry etching, wet etching, or the like to expose the first through silicon via 2003.

It should be understood that, when the first substrate 2001 is thinned, the first insulation layer 2008, the first conductive barrier layer 2007, and the electroplated seed layer 2009b at the bottom of the first through silicon via 2003 are removed. In this case, the first through silicon via 2003 includes an electroplated column 2009, and the first conductive barrier layer 2007 and the insulation layer 2009b that sequentially wrap the side surface of the electroplated column 2009, and the first conductive barrier layer 2007 and the first insulation layer 2008 are not disposed on the upper and lower bottom surfaces of the electroplated column 2009. The electroplated column 2009 includes the conductive column 2009a and the electroplated seed layer 2009b that wraps a side surface of the conductive column 2009a, and the electroplated seed layer 2009b is not disposed on the upper and lower bottom surfaces of the conductive column 2009a.

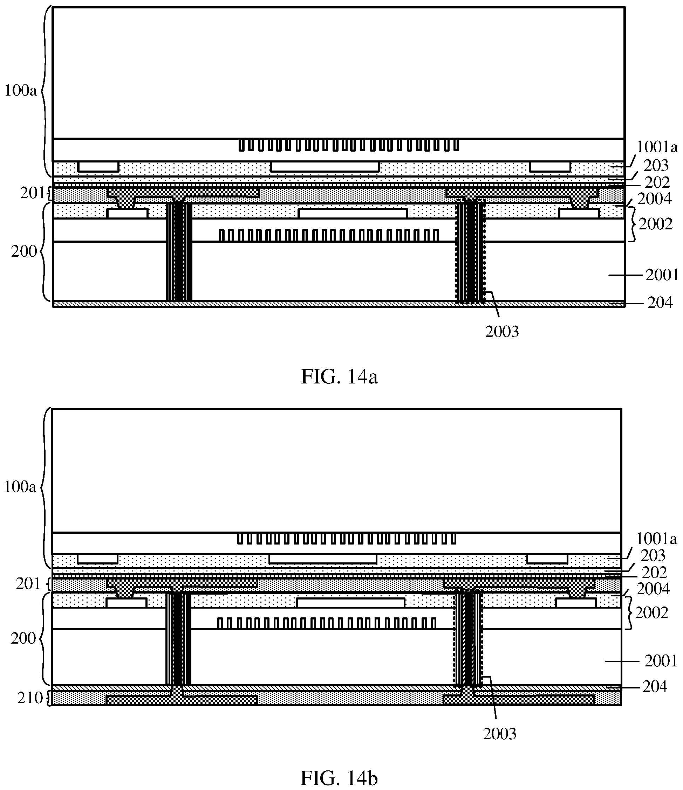

In some examples, after the first substrate 2001 is thinned to expose the first through silicon via 2003, to protect the first substrate 2001, step S14 further includes: as shown in FIG. 14a, forming a first insulation barrier layer 204 on a side that is of the first substrate 2001 and that is away from the first functional layer 2002, where the first insulation barrier layer 204 is configured to protect the first substrate 2001.

For a material of the first insulation barrier layer 204, refer to the material of the second insulation barrier layer. Details are not described herein again.

In some examples, after step S14 and before the following step S15, the method for manufacturing the chip stacked structure 10 further includes: as shown in FIG. 14b, forming a second redistribution layer 210 on the first substrate 2001, where the second redistribution layer 210 is electrically connected to the first through silicon vias 2003.

For a structure and a specific manufacturing process of the second redistribution layer 210, refer to the structure and the specific manufacturing process of the third redistribution layer 201 in step S12. Details are not described herein again.

It may be understood that, when the stress of the first through silicon via 2003 is large, the second redistribution layer 210 can reduce the internal stress of the first through silicon via 2003.

When the first insulation barrier layer 204 is formed on a side that is of the first substrate 2001 and that is away from the first functional layer 2002, the second redistribution layer 210 is electrically connected to the first through silicon via 2003 through vias on the first insulation barrier layer 204.

S15: Form a first dielectric sub-layer on the first substrate 2001, where the first dielectric sub-layer includes a plurality of first hybrid bonding vias in a one-to-one correspondence with the first through silicon vias 2003.

A material of the first dielectric sub-layer may be, for example, one or more of silicon nitride, silicon oxide, silicon oxynitride, or silicon carbide.

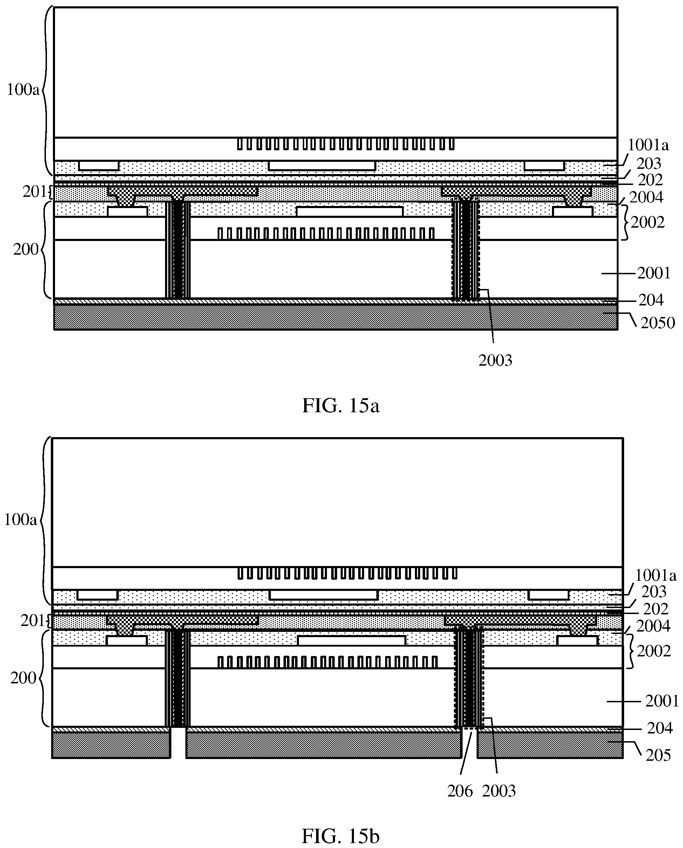

For example, the forming a first dielectric sub-layer on the first substrate 2001 may include:
S150: As shown in FIG. 15a, deposit a first dielectric thin film 2050 on the first substrate 2001. It should be understood that, when the first insulation barrier layer 204 is formed on the first substrate 2001, the first dielectric thin film 2050 is deposited on the first insulation barrier layer 204. When the second redistribution layer 210 is formed on the first substrate 2001, the first dielectric thin film 2050 is deposited on the second redistribution layer 210. FIG. 14a shows the second redistribution layer 210, and FIG. 15a does not show the second redistribution layer 210.
S151: As shown in FIG. 15b, etch the first dielectric thin film 2050 to form a plurality of first hybrid bonding vias 206.

The etching the first dielectric thin film 2050 to form a plurality of first hybrid bonding vias 206 specifically includes: coating a photoresist thin film on the first dielectric thin film 2050; performing a process such as mask exposure and development on the photoresist thin film, to form a plurality of hollow areas on the photoresist thin film; and etching the first dielectric thin film 2050 to form the plurality of first hybrid bonding vias 206.

It should be noted that, in some examples, when the first insulation barrier layer 204 is formed on the first substrate 2001, and the second redistribution layer 210 is not formed, the first insulation barrier layer 204 is also etched when the first dielectric thin film 2050 is etched, and vias in a one-to-one correspondence with the plurality of first hybrid bonding vias 206 are also formed in the first insulation barrier layer 204.

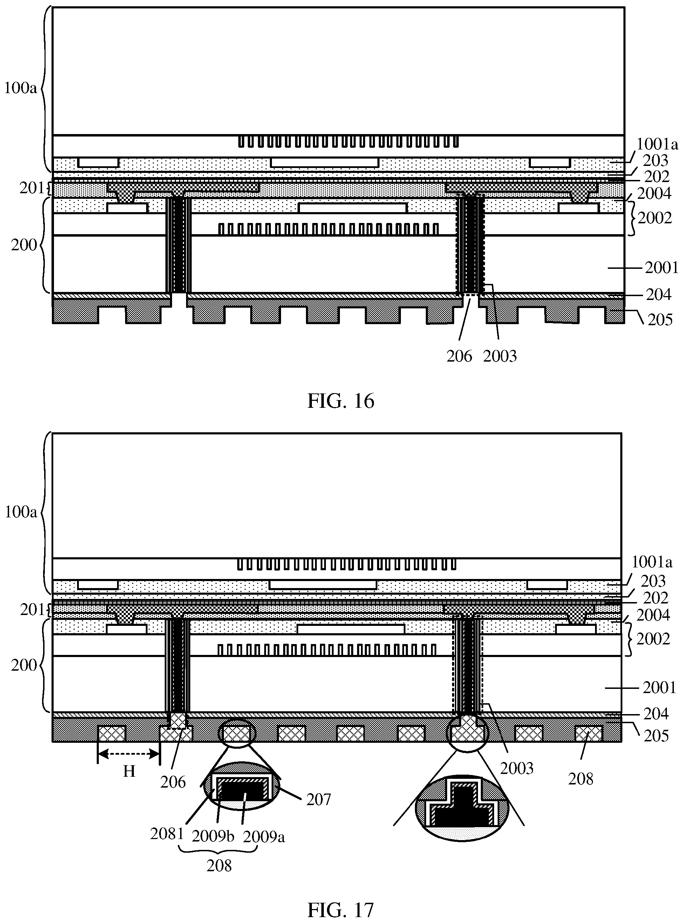

S16: As shown in FIG. 17, form a plurality of first bonding metal sub-blocks 208 in the first dielectric sub-layer 205, where the first bonding metal sub-block 208 is exposed on a surface that is of the first dielectric sub-layer 205 and that is away from the first substrate 2001, and at least some of the first bonding metal sub-blocks 208 are electrically connected to the first through silicon vias 2003.

It should be noted that the first bonding metal sub-block 208 may be directly electrically connected to the first through silicon via 2003, or may be indirectly electrically connected to the first through silicon via 2003 through another structure. For example, when the first hybrid bonding via 206 is formed on the first dielectric sub-layer 205, the first bonding metal sub-block 208 is electrically connected to the first through silicon via 2003 through the first hybrid bonding via 206. For another example, when the second redistribution layer 210 is formed between the first substrate 2001 and the first dielectric sub-layer 205, the first bonding metal sub-block 208 is electrically connected to the first through silicon via 2003 through the first hybrid bonding via 206 and the second redistribution layer 210.

Based on this, when the second redistribution layer 210 is formed on the first substrate 2001, because the first bonding metal sub-block 208 may be electrically connected to the first through silicon via 2003 through the second redistribution layer 210, a projection of the first bonding metal sub-blocks 208 on the first chip 200 may have an overlapping area with the first through silicon vias 2003, or may have no overlapping area.

For example, step S16 may include:
S160: As shown in FIG. 16, etch the first dielectric sub-layer 205, to form, on the first dielectric sub-layer 205, a plurality of groove areas for forming the first bonding metal sub-blocks 208.

The etching the first dielectric sub-layer 205 in step S160 specifically includes: coating a photoresist thin film; performing a process such as mask exposure and development on the photoresist thin film to form a plurality of hollow areas on the photoresist thin film; and etching the dielectric thin film to form the first dielectric sub-layer 205, where the first dielectric sub-layer 205 includes a plurality of hollow areas for forming the first bonding metal sub-blocks 208.

To avoid etching the first through silicon vias 2003 in a process of etching the hollow areas that are in the first dielectric sub-layer 205 and that are used to form the first bonding metal sub-blocks 208, in some examples, after step S15 and before step S16, the first hybrid bonding vias 206 in the first dielectric sub-layer 205 may be filled with organic matter. In step S160, the organic matter is etched off when the first dielectric sub-layer 205 is etched.

S161: As shown in FIG. 17, deposit the third conductive barrier layer 2081 and the electroplated seed layer 2009b sequentially, and electroplate the conductive layer 2009a, for example, copper, by using an electroplating process; and then remove the third conductive barrier layer 2081, the electroplated seed layer 2009b, and the conductive layer 2009a that are outside the groove areas of the first dielectric sub-layer 205 by using a chemical mechanical polishing process, to form the first bonding metal sub-blocks 208 in the first hybrid bonding vias 206 and the groove areas of the first dielectric sub-layer 205. The first bonding metal sub-block 208 includes the third conductive barrier layer 2081, the electroplated seed layer 2009b, and the conductive layer 2009a.

It should be noted that, when the first bonding metal sub-block 208 is in contact with the first through silicon via 2003, and the first bonding metal sub-block 208 is formed through step S160 and step S161, the conductive barrier layer under the first through silicon via 2003 is discontinuous with the first conductive barrier layer 2007 formed on the side surface of the electroplated column 2009. The conductive barrier layer under the first through silicon via 2003 is not the first conductive barrier layer 2007 but the third conductive barrier layer 2081, and is a part belonging to the first bonding metal sub-block 208.

In some examples, after step S 160 and before step S 161, step S 16 further includes: cleaning the structure formed in step S160.

It may be understood that the first hybrid bonding via 206 formed in step S15 can ensure that in the plurality of first bonding metal sub-blocks 208 formed in step S16, except that some first bonding metal sub-blocks 208 are electrically connected to the first through silicon via 2003, other first bonding metal sub-blocks 208 are not electrically connected to the circuit structure. In this way, the plurality of first bonding metal sub-blocks 208 formed in step S16 can be evenly distributed.

In step S15 and step S16, the method for manufacturing the chip stacked structure 10 is described by using an example in which the first dielectric sub-layer 205 includes a plurality of first hybrid bonding vias 206. In some examples, the first dielectric sub-layer 205 formed in step S15 may alternatively not include the first hybrid bonding vias 206. In this case, in step S 160, the first dielectric sub-layer 205 is etched, to form, on the first dielectric sub-layer 205, a plurality of hollow areas for forming the first bonding metal sub-blocks 208.

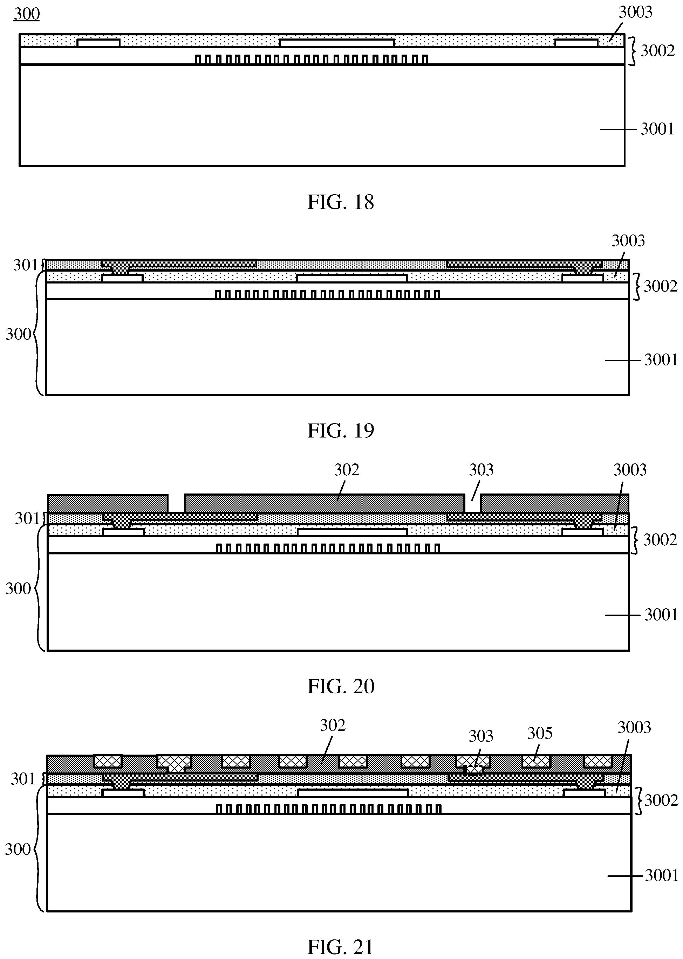

S17: As shown in FIG. 18, provide a second chip 300, where the second chip 300 includes a second substrate 3001 and a second functional layer 3002 disposed on the second substrate 3001.

The second functional layer 3002 includes a functional device, a circuit structure, an interconnection metal wire, a dielectric layer, and the like. In other words, the second chip 300 provided in step S17 is a chip that has complete functions and completes a front-end device, a circuit structure, and a back-end metal interconnection process. The second chip 300 may be a wafer or a bare chip.

In some examples, step S17 further includes: as shown in FIG. 18, forming a third flat layer 3003 on the second functional layer 3002 of the second chip 300, to perform flatness processing on a surface of the second chip 300.

S18: As shown in FIG. 19, form a first redistribution layer 301 on the second functional layer 3002.

It should be noted that for step S18, refer to step S12. Details are not described herein again.

For a structure of the first redistribution layer 301, refer to the foregoing third redistribution layer 201. Details are not described herein again.

In addition, the first redistribution layer 301 may be formed, for example, by using a Damascus process. In this case, for a manufacturing process of the first redistribution layer 301, refer to the specific manufacturing process in step S12.

In addition, the first redistribution layer 301 may be electrically connected to the second functional layer 3002, or may be not electrically connected to the second functional layer 3002. FIG. 19 is illustrated by using an example in which the first redistribution layer 301 is electrically connected to the second functional layer 3002. When the first redistribution layer 301 is electrically connected to the second functional layer 3002, interconnection between the second chip 300 and the first through silicon via 2003 can be implemented.

S19: As shown in FIG. 20, form a second dielectric sub-layer 302 on the first redistribution layer 301, where the second dielectric sub-layer 302 includes a plurality of second hybrid bonding vias 303.

It should be noted that the forming a second dielectric sub-layer 302 on the first redistribution layer 301 specifically includes: forming a second dielectric thin film on the first redistribution layer 301, and etching the second dielectric thin film to form a plurality of second hybrid bonding vias 303, to form the second dielectric sub-layer 302. The second dielectric sub-layer 302 includes the plurality of second hybrid bonding vias 303. For a specific implementation step of step S19, refer to step S15. Details are not described herein again.

For a material of the second dielectric sub-layer 302, refer to the material of the first dielectric sub-layer 205. Details are not described herein again.

S20: As shown in FIG. 21, form a plurality of second bonding metal sub-blocks 305 in the second dielectric sub-layer 302, where the second bonding metal sub-block 305 is exposed on a surface that is of the second dielectric sub-layer 302 and that is away from the second substrate 3001, and at least some of the second bonding metal sub-blocks 305 are electrically connected to the first redistribution layer 301.

It should be noted that the second bonding metal sub-block 305 may be directly electrically connected to the first redistribution layer 301, or may be indirectly electrically connected to the first redistribution layer 301 through another structure. For example, when the second dielectric sub-layer 302 includes a plurality of second hybrid bonding vias 303, the second bonding metal sub-block 305 is electrically connected to the first redistribution layer 301 through the second hybrid bonding vias 303.

In addition, for a process of forming the plurality of second bonding metal sub-blocks 305 in the second dielectric sub-layer 302, refer to step S16. For a specific structure of the second bonding metal sub-block 305, refer to the specific structure of the first bonding metal sub-block 208. Details are not described herein again.

It may be understood that the second hybrid bonding via 303 formed in step S19 can ensure that in the plurality of second bonding metal sub-blocks 305 formed in step S20, except that some second bonding metal sub-blocks 305 are electrically connected to the first redistribution layer 301, other second bonding metal sub-blocks 305 are not electrically connected to the circuit structure. In this way, the plurality of second bonding metal sub-blocks 305 formed in step S20 can be evenly distributed.

In step S19 and step S20, the method for manufacturing the chip stacked structure 10 is described by using an example in which the second dielectric sub-layer 302 includes a plurality of second hybrid bonding vias 303. In some examples, the second dielectric sub-layer 302 formed in step S19 may alternatively not include the second hybrid bonding vias 303.

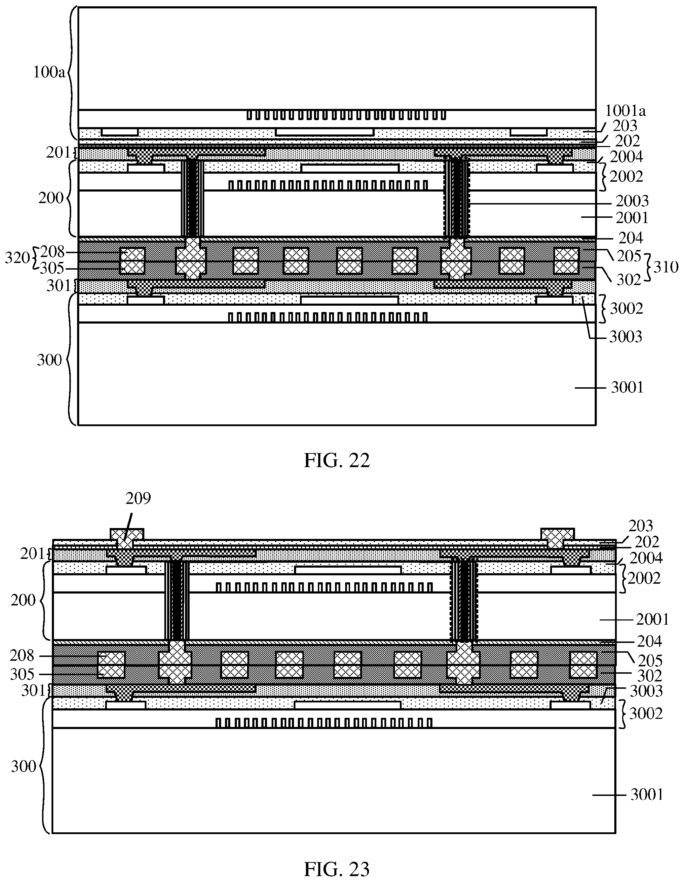

Based on the foregoing description, the first dielectric layer 310 shown in FIG. 22 and the plurality of first bonding metal blocks 320 located in the first dielectric layer 310 may be formed between the first substrate 2001 and the first redistribution layer 301 through step S15, step S16, step S19, and step S20. The first dielectric layer 310 includes the first dielectric sub-layer 205 and the second dielectric sub-layer 302. Each first bonding metal block 320 includes a first bonding metal sub-block 208 and a second bonding metal sub-block 305 that are mutually bonded.

S21: As shown in FIG. 22, bond a first chip 200 and a second chip 300 through the first dielectric layer 310 and the first bonding metal block 320, where at least some of the first bonding metal blocks 320 are electrically connected to the first through silicon vias 2003 and the first redistribution layer 301 respectively.

Because the first chip 200 and the second chip 300 are bonded through the first dielectric layer 310 and the first bonding metal blocks 320, it may be considered that the first chip 200 and the second chip 300 are bonded in a hybrid bonding (hybrid bonding) manner.

It may be understood that the first chip 200 and the second chip 300 are bonded through the first dielectric layer 310 and the first bonding metal block 320. Specifically, the first dielectric sub-layer 205 disposed on the first chip 200 is bonded with the second dielectric sub-layer 302 disposed on the second chip 300, and the plurality of first bonding metal sub-blocks 208 disposed on the first chip 200 are bonded with the plurality of second bonding metal sub-blocks 305 disposed on the second chip 300 in a one-to-one correspondence.

Because the first bonding metal sub-block 208 is disposed on the back side of the first chip 200, the second bonding metal sub-block 305 is disposed on the front side of the second chip 300, the plurality of first bonding metal sub-blocks 208 and the plurality of second bonding metal sub-blocks 305 are bonded in a one-to-one correspondence, that is, the back side of the first chip 200 and the front side of the second chip 300 are bonded.

When the third redistribution layer 201 is electrically connected to the first functional layer 2002, and the first redistribution layer 301 is electrically connected to the second functional layer 3002, because the first through silicon via 2003 is electrically connected to the third redistribution layer 201 and the first bonding metal sub-block 208, the second bonding metal sub-block 305 is electrically connected to the first redistribution layer 301, and the first bonding metal sub-block 208 and the second bonding metal sub-block 305 are bonded, the first functional layer 2002 and the second functional layer 3002 may be electrically connected through the third redistribution layer 201, the first through silicon via 2003, the first bonding metal sub-block 208, the second bonding metal sub-block 305, and the first redistribution layer 301, that is, electrical interconnection between the first chip 200 and the second chip 300 is implemented.

S22: As shown in FIG. 23, remove the carrier 100a, and form a lead structure (pad) 209 on a side of the first functional layer 2002 of the first chip 200, where the lead structure 209 is electrically connected to the first through silicon vias 2003. Interconnection between the chip stacked structure 10 and the outside can be implemented through the lead structure 209.

When the third redistribution layer 201 is formed on the first functional layer 2002, the lead structure 209 may be electrically connected to the first through silicon via 2003 through the third redistribution layer 201.

It may be understood that, before step S22, the carrier 100a is located on the top of the reverse side of the chip stacked structure 10 manufactured in step S10 to step S21, and then the carrier 100a is removed.

Based on the foregoing method for manufacturing the chip stacked structure 20, when the first through silicon via 2003 on the first chip 200 is manufactured, the first through silicon via 2003 is formed from a side of the first functional layer 2002 of the first chip 200, that is, the first through silicon via 2003 is manufactured from the front side of the first chip 200. In this way, only the dielectric layer and the first substrate 2001 that are on the front side of the first chip 200 need to be etched. When two-layer stacking between wafers is implemented through wafer bonding, the process of forming the through silicon via requires at least etching the dielectric layer in the functional layer on the front side of the chip, as well as etching the substrate and the dielectric layer on the back side of the chip (where the dielectric layer on the back side of the chip may include a flat layer, a hard mask, and the like). By contrast, in embodiments of this application, the process of etching the dielectric layer on the back side of the first chip 200 is reduced in the process of forming the first through silicon via 2003 through etching. Therefore, the process of forming the first through silicon via 2003 in embodiments of this application is simpler. In addition, in this application, because the first through silicon via 2003 is formed from a side of the first functional layer 2002 of the first chip 200, in a process of manufacturing the first through silicon via 2003, the first through silicon via 2003 may penetrate the first substrate 2001 or stop at any position in the first substrate 2001. When a TSV is manufactured from a side of a silicon substrate of a first wafer, a high requirement is imposed on a depth of the TSV, and the manufactured TSV should be in contact with a circuit structure in a functional layer. By contrast, in embodiments of this application, difficulty in manufacturing the first through silicon via 2003 can be further reduced.

In addition, when the first through silicon via 2003 formed in this embodiment of this application does not penetrate the first substrate 2001, and the first through silicon via 2003 is subsequently exposed by thinning the first substrate 2001, only the dielectric layer on the front side of the first chip 200 and a part of the first substrate 2001 need to be etched when the first through silicon via 2003 is manufactured, difficulty in manufacturing the first through silicon via 2003 can be further reduced.

Based on this, when at least one of the first chip 200 and the second chip 300 is a wafer, in a process of stacking the first chip 200 and the second chip 300, because a processing capability of the wafer is fine, a size of the first bonding metal sub-block 208 formed on the first chip 200 and a size of the second bonding metal sub-block 305 formed on the second chip 300 may be small. Therefore, a pitch between adjacent first bonding metal sub-blocks 208 and a pitch between adjacent second bonding metal sub-blocks 305 are small, that is, a pitch between adjacent first bonding metal blocks 320 is small. Refer to FIG. 17, a pitch H between adjacent first bonding metal blocks 320 may reach 0.5 µm to 15 µm. In this way, the density of the first bonding metal sub-blocks 208 disposed on the first chip 200 and the density of the second bonding metal sub-blocks 305 disposed on the second chip 300 increase, so that the interconnection density between the first chip 200 and the second chip 300 can be increased, and the interconnection bandwidth between the first chip 200 and the second chip 300 can be increased. Compared with interconnection between adjacent chips implemented through a micro bump, when interconnection between the first chip 200 and the second chip 300 is implemented through the first bonding metal sub-block 208 and the second bonding metal sub-block 305, an interconnection density per square millimeter can be increased by more than 10 times, and even more than 1000 times at most.

In addition, when both the first chip 200 and the second chip 300 are wafers, because alignment precision between the wafer and the wafer is high, a size of the first bonding metal sub-block 208 formed on the first chip 200 may be further reduced, that is, a pitch between adjacent first bonding metal sub-blocks 208 may be further reduced. Similarly, a size of the second bonding metal sub-block 305 formed on the second chip 300 may be further reduced, that is, a pitch between adjacent second bonding metal sub-blocks 305 may be further reduced. In other words, a pitch between adjacent first bonding metal blocks 320 may be further reduced, thereby further improving the interconnection density between the first chip 200 and the second chip 300, and further improving the interconnection bandwidth between the first chip 200 and the second chip 300.

In addition, the first chip 200 and the second chip 300 are directly bonded through the first dielectric layer 310 and the first bonding metal block 320. Therefore, after the first chip 200 and the second chip 300 are stacked, there is no need to fill a filling material between the first chip 200 and the second chip 300. In one aspect, the process can be simplified. In another aspect, because the filling material is generally an organic material, a substrate of the first chip 200 and the second chip 300 is generally a silicon substrate, and a difference between thermal expansion coefficients of the organic material and the silicon substrate is large, the filling material causes a stress matching problem. In addition, a material of the first dielectric layer 310 is generally one or more of silicon nitride, silicon oxide, silicon oxynitride, silicon carbide, and the like, and silicon nitride, silicon oxide, silicon oxynitride, and silicon carbide have thermal expansion coefficients close to that of the silicon substrate. Therefore, this application can further avoid the stress matching problem caused by the filling material.

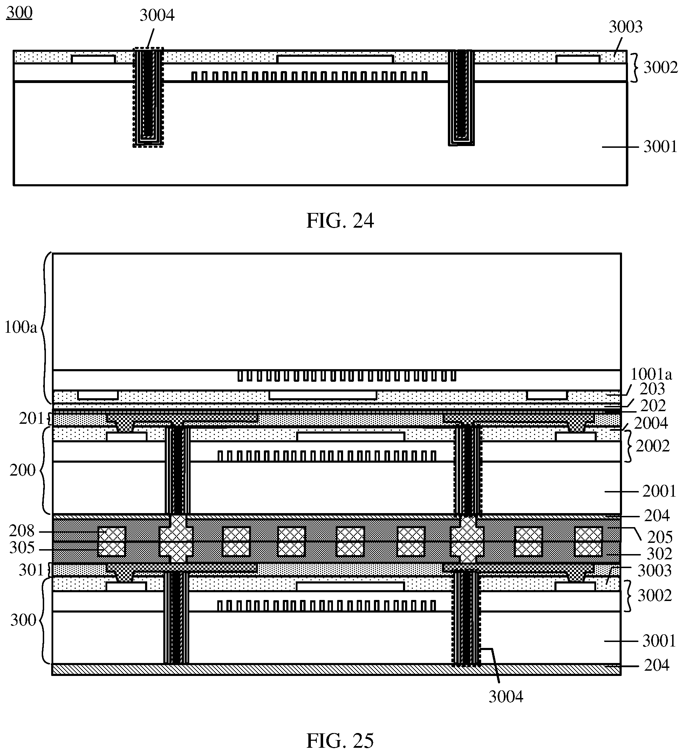

The foregoing steps S10 to S22 describe a method for manufacturing the chip stacked structure 10 by using an example in which the chip stacked structure 10 includes a first chip 200 and a second chip 300 that are sequentially stacked. When the chip stacked structure 10 further includes a third chip 400, after step S17 and before step S18, the method for manufacturing the chip stacked structure 10 further includes:
S23: As shown in FIG. 24, form second through silicon vias 3004 from a side of the second functional layer 3002 of the second chip 300.

For a specific structure of the second through silicon via 3004 and a specific process of forming the second through silicon via 3004, refer to step S11. Details are not described herein again.

It should be noted that, when the first redistribution layer 301 is formed in step S18, the first redistribution layer 301 is electrically connected to the second through silicon via 3004.

In addition, a projection of the second through silicon vias 3004 on the first chip 200 may have an overlapping area with the first through silicon vias 2003, or a projection of the second through silicon via 3004 on the first chip 200 may have no overlapping area with the first through silicon vias 2003.

After step S21 and before step S22, the method for manufacturing the chip stacked structure 10 further includes:
S24: As shown in FIG. 25, thin the second substrate 3001 from a side that is of the second substrate 3001 and that is away from the second functional layer 3002 to expose the second through silicon vias 3004.

For step S24, refer to step S14. Details are not described herein again.

It should be noted that step S24 is an optional step. In some examples, when the second through silicon via 3004 formed in step S23 penetrates the second substrate 3001, step S24 may be omitted. When the second through silicon via 3004 formed in step S23 does not penetrate the second substrate 3001, step S24 needs to be performed.

Based on this, in some examples, after the second substrate 3001 is thinned to expose the second through silicon via 3004, step S24 further includes: as shown in FIG. 25, forming a first insulation barrier layer 204 on a side that is of the second substrate 3001 and that is away from the second functional layer 3002, where the first insulation barrier layer 204 is configured to protect the second substrate 3001.

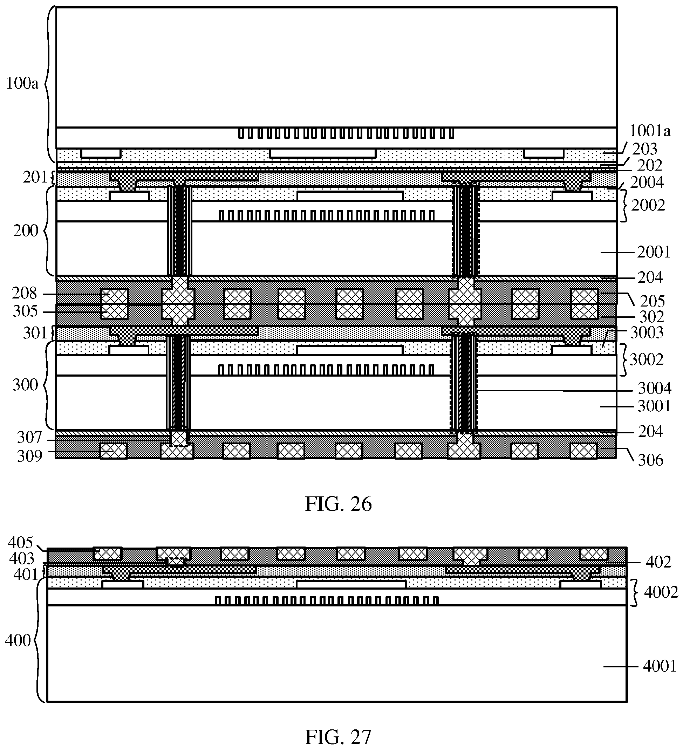

S25: As shown in FIG. 26, form a third dielectric sub-layer 306 on the second substrate 3001, where the third dielectric sub-layer 306 includes a plurality of third hybrid bonding vias 307 in a one-to-one correspondence with the second through silicon vias 3004.

It should be noted that, for step S25, refer to step S15. Details are not described herein again.

S26: As shown in FIG. 26, form a plurality of third bonding metal sub-blocks 309 in the third dielectric sub-layer 306, where the third bonding metal sub-block 309 is exposed on a surface that is of the third dielectric sub-layer 306 and that is away from the second substrate 3001, and at least some of the third bonding metal sub-blocks 309 are electrically connected to the second through silicon vias 3004.

It should be noted that, for step S26, refer to step S16. Details are not described herein again.

S27: As shown in FIG. 27, provide a third chip 400, where the third chip 400 includes a third substrate 4001 and a third functional layer 4002 disposed on the third substrate 4001.

It should be noted that, for step S27, refer to step S17. Details are not described herein again.

S28: As shown in FIG. 27, form a fourth redistribution layer 401 on the third functional layer 4002.

It should be noted that, for step S27, refer to step S18. Details are not described herein again.

S29: As shown in FIG. 27, form a fourth dielectric sub-layer 402 on the fourth redistribution layer 401, where the fourth dielectric sub-layer 403 includes a plurality of fourth hybrid bonding vias 403.

It should be noted that, for step S29, refer to step S19. Details are not described herein again.

S30: As shown in FIG. 27, form a plurality of fourth bonding metal sub-blocks 405 in the fourth dielectric sub-layer 402, where the fourth bonding metal sub-block 405 is disposed in the fourth dielectric sub-layer 402, and is exposed on a surface that is of the fourth dielectric sub-layer 402 and that is away from the third substrate 4001, and at least some of the fourth bonding metal sub-blocks 405 are electrically connected to the fourth redistribution layer 401.

It should be noted that, for step S30, refer to step S20. Details are not described herein again.

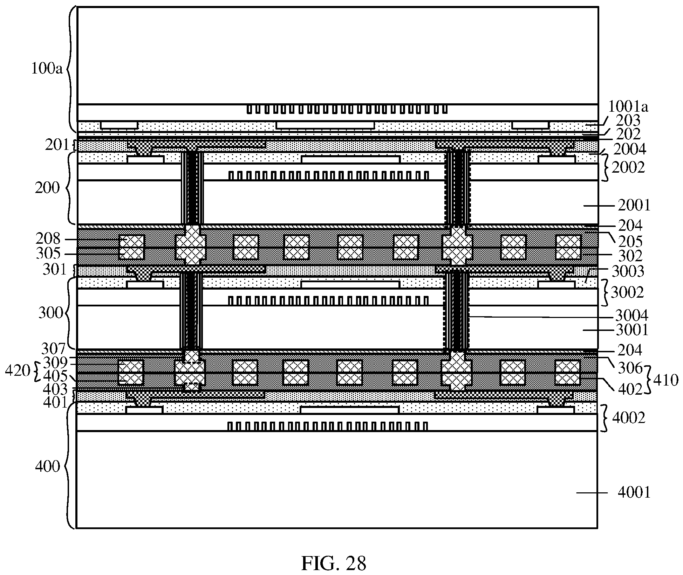

It may be understood that the second dielectric layer 410 shown in FIG. 28 and the plurality of second bonding metal blocks 420 located in the second dielectric layer 410 may be formed between the second substrate 3001 and the fourth redistribution layer 401 through step S25, step S26, step S29, and step S30. The second dielectric layer 410 includes the third dielectric sub-layer 306 and the fourth dielectric sub-layer 402. Each second bonding metal block 420 includes a third bonding metal sub-block 309 and a fourth bonding metal sub-block 405 that are mutually bonded.

S31: As shown in FIG. 28, bond the second chip 300 and the third chip 400 through the second dielectric layer 410 and the second bonding metal block 420, where at least some of the second bonding metal blocks 420 are electrically connected to the second through silicon vias 3001 and the fourth redistribution layer 401 respectively.

Because the second chip 300 and the third chip 400 are bonded through the second dielectric layer 410 and the second bonding metal blocks 420, it may be considered that the second chip 300 and the third chip 400 are bonded in a hybrid bonding manner.

It may be understood that the second chip 300 and the third chip 400 are bonded through the second dielectric layer 410 and the second bonding metal blocks 420. Specifically, the third dielectric sub-layer 306 and the fourth dielectric sub-layer 402 are bonded, and the plurality of third bonding metal sub-blocks 309 and the plurality of fourth bonding metal sub-blocks 405 are bonded in a one-to-one correspondence.

It should be noted that, for step S31, refer to step S21. Details are not described herein again. Interconnection between the second chip 300 and the third chip 400 can be implemented through step S31.

The interconnection between the second chip 300 and the third chip 400 has the same technical effect as the interconnection between the first chip 200 and the second chip 300. Refer to the foregoing description. Details are not described herein again.

Based on the foregoing description, when the chip stacked structure 10 further includes a fourth chip, a fifth chip, and the like, the fourth chip, the fifth chip, and the like may be stacked with reference to the foregoing steps S23 to S31. A structure obtained through stacking is shown in FIG. 4a.

Based on the foregoing method for manufacturing the chip stacked structure 10, a specific structure of the chip stacked structure 10 is described by using an example in which the chip stacked structure 10 includes the first chip 200 and the second chip 300 that are sequentially stacked.

As shown in FIG. 4a, the chip stacked structure 10 includes a first chip 200 and a second chip 300 that are sequentially stacked. The first chip 200 includes a first substrate 2001 and a first functional layer 2002 disposed on the first substrate 2001. To implement interconnection between the first chip 200 and the second chip 300, the first chip 200 further includes first through silicon vias 2003 that penetrate the first substrate 2001 and the first functional layer 2002. When the first through silicon via 2003 is manufactured, the first through silicon via 2003 is formed from a side of the first functional layer 2002 of the first chip 200. Therefore, referring to FIG. 4a, a diameter of the first through silicon via 2003 close to the first functional layer 2003 is greater than a diameter of the first through silicon via close to the first substrate 2001.

The second chip 300 includes a second substrate 3001 and a second functional layer 3002 disposed on the second substrate 3001.

For materials of the first substrate 2001 and the second substrate 3001, and structures of the first functional layer 2002 and the second functional layer 3002, refer to the foregoing description. Details are not described herein again.

Still refer to FIG. 4a, the chip stacked structure 10 further includes a first redistribution layer 301 disposed on a side that is of the second functional layer 3002 and that is away from the second substrate 3001, a first dielectric layer 310 disposed between the first substrate 2001 and the first redistribution layer 301, and a plurality of first bonding metal blocks 320 disposed in the first dielectric layer 310. At least some of the first bonding metal blocks 320 are electrically connected to the first through silicon vias 2003 and the first redistribution layer 301 respectively. The first chip 200 and the second chip 300 are bonded through the first dielectric layer 310 and the first bonding metal block 320, that is, the first chip 200 and the second chip 300 are bonded through hybrid bonding.

It should be noted that, when the first through silicon via 2003 is manufactured from a side of the first functional layer 2002 of the first chip 200, in some examples, the first through silicon via 2003 includes an electroplated column 2009 and a first conductive barrier layer 2007 that wraps a side surface of the electroplated column 2009, and the first conductive barrier layer 2007 is not disposed on a surface that is of the electroplated column 2009 and that is away from the second chip 300.

When the first through silicon via 2003 is manufactured from a side of the first functional layer 2002 of the first chip 200, and the first substrate 2001 is thinned from a side that is of the first substrate 2001 and that is away from the first functional layer 2002 to expose the first through silicon via 2003, in some examples, the first conductive barrier layer 2007 is not disposed on the surface that is of the electroplated column 2009 and that is away from the second chip 300 and the surface that is close to the second chip 200.

For materials of the electroplated column 2009, the seed layer 2009b, and the first conductive barrier layer 2007, refer to the foregoing description. Details are not described herein again.

Still refer to FIG. 4a. In some examples, the first bonding metal block 320 includes a first bonding metal sub-block 208 and a second bonding metal sub-block 305 that are mutually bonded. The first bonding metal sub-block 208 is close to the first through silicon via 2003, and the second bonding metal sub-block 305 is close to the first redistribution layer 301.

The first dielectric layer 310 includes a first dielectric sub-layer 205 and a second dielectric sub-layer 302 that are mutually bonded. The first dielectric sub-layer 205 is close to the first substrate 2001, and the second dielectric sub-layer 302 is close to the first redistribution layer 301. The first bonding metal sub-block 208 is disposed in the first dielectric sub-layer 205 and is exposed on a surface that is of the first dielectric sub-layer 205 and that is away from the first substrate 2001. The second bonding metal sub-block 305 is disposed in the second dielectric sub-layer 302, and is exposed on a surface that is of the second dielectric sub-layer 302 and that is away from the first redistribution layer 301.

Based on the foregoing structures of the first bonding metal block 320 and the first dielectric layer 310, the first dielectric sub-layer 205 and the first bonding metal sub-block 208 are formed on the side that is of the first substrate 2001 and that is away from the first functional layer 2002, the second dielectric sub-layer 302 and the second bonding metal sub-block 305 are formed on the side that is of the first redistribution layer 301 and that is away from the second functional layer 3002, the first dielectric sub-layer 205 and the second dielectric sub-layer 302 are bonded, and the first bonding metal sub-block 208 and the second bonding metal sub-block 305 are bonded, so that the first chip 200 and the second chip 300 can be bonded through the first dielectric layer 310 and the first bonding metal blocks 320.

It may be understood that the first bonding metal sub-block 208 may be directly electrically connected to the first through silicon via 2003, or may be electrically connected to the first through silicon via 2003 through another structure. In some examples, as shown in FIG. 4a, the first dielectric sub-layer 205 includes a plurality of first hybrid bonding vias 206, and the first bonding metal sub-block 208 is electrically connected to the first through silicon via 2003 through the first hybrid bonding via 206. The first hybrid bonding via 206 can ensure that, except that some first bonding metal sub-blocks 208 are electrically connected to the first through silicon vias 2003, other first bonding metal sub-blocks 208 are not electrically connected to the circuit structure. In this way, the plurality of first bonding metal sub-blocks 208 can be evenly distributed.

Similarly, the second bonding metal sub-block 305 may be directly electrically connected to the first redistribution layer 301, or may be electrically connected to the first redistribution layer 301 through another structure. In some examples, as shown in FIG. 4a, the second dielectric sub-layer 302 includes a plurality of second hybrid bonding vias 303, and the second bonding metal sub-block 305 is electrically connected to the first redistribution layer 301 through the second hybrid bonding via 303. The first hybrid bonding via 206 can ensure that, except that some second bonding metal sub-blocks 305 are electrically connected to the first redistribution layer 301, other second bonding metal sub-blocks 305 are not electrically connected to the circuit structure. In this way, the plurality of second bonding metal sub-blocks 305 can be evenly distributed.

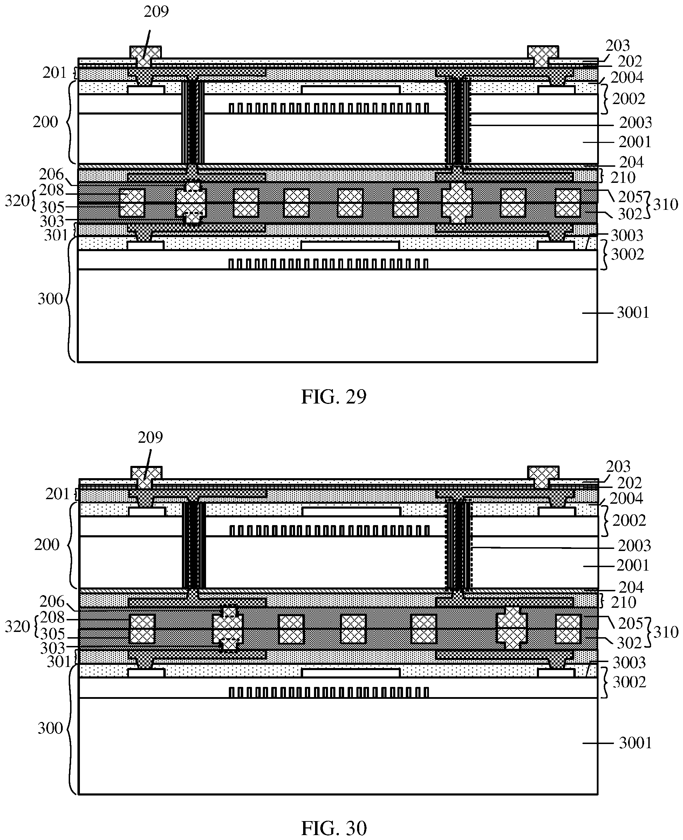

Considering that the internal stress of the first through silicon via 2003 is generally large, to alleviate the internal stress of the first through silicon via 2003, in some examples, as shown in FIG. 29, the chip stacked structure 10 further includes a second redistribution layer 210 disposed between the first substrate 2001 and the first dielectric layer 310, and the second redistribution layer 210 is electrically connected to the first through silicon vias 2003 and the first bonding metal blocks 320. The internal stress of the first through silicon via 2003 can be alleviated through the second redistribution layer 210.

In addition, for a structure and a material of the second redistribution layer 210, refer to the foregoing description. Details are not described herein again.

When the chip stacked structure 10 includes the second redistribution layer 210, the first bonding metal block 320 is electrically connected to the first through silicon via 2003 through the second redistribution layer 210.

Based on this, when the chip stacked structure 10 includes the second redistribution layer 210, as shown in FIG. 29, a projection of the first bonding metal blocks 320 on the first chip 200 has an overlapping area with the first through silicon vias 2003; or as shown in FIG. 30, a projection of the first bonding metal blocks 320 on the first chip 200 has no overlapping area with the first through silicon vias 2003.

When the projection of the first bonding metal blocks 320 on the first chip 200 has no overlapping area with the first through silicon vias 2003, a stress concentration problem can be avoided.

Considering that when another film layer is manufactured on the side that is of the first substrate 2001 and that is away from the first functional layer 2002, the first substrate 2001 may be etched in the process of manufacturing the another film layer, based on this, in some examples, as shown in FIG. 30, the chip stacked structure 10 further includes a first insulation barrier layer 204 disposed between the first substrate 2001 and the first dielectric layer 310. When the chip stacked structure 10 includes the second redistribution layer 210, the first insulation barrier layer 204 is disposed between the first substrate 2001 and the second redistribution layer 210. The first insulation barrier layer 204 includes a plurality of hollow areas, and the first bonding metal blocks 320 are electrically connected to the first through silicon vias 2003 through the hollow areas on the first insulation barrier layer 204. The first insulation barrier layer 204 can protect the first substrate 2001.

In addition, for a material of the first insulation barrier layer 204, refer to the foregoing description. Details are not described herein again.

To facilitate manufacturing of another film layer on the first functional layer 2002 of the first chip 200, in some examples, as shown in FIG. 30, the chip stacked structure 10 further includes a first flat layer 2004 disposed on the first functional layer 2002.

In some examples, as shown in FIG. 30, the chip stacked structure 10 further includes a third redistribution layer 201 disposed on a side that is of the first functional layer 2002 and that is away from the first substrate 2001, where the third redistribution layer 201 is electrically connected to the first through silicon vias 2003.

It should be noted that, for a structure and a function of the third redistribution layer 201, refer to the foregoing description. Details are not described herein again.

In some examples, as shown in FIG. 30, the chip stacked structure 10 further includes a third insulation barrier layer 202 and a second flat layer 203 that are disposed on a side that is of the third redistribution layer 201 and that is away from the first functional layer 2002.

For materials and functions of the third insulation barrier layer 202 and the second flat layer 203, refer to the foregoing description. Details are not described herein again.

In some examples, as shown in FIG. 30, the chip stacked structure 10 further includes a lead structure 209 disposed on a side that is of the first functional layer 2002 and that is away from the first substrate 2001, where the lead structure 209 is electrically connected to the first through silicon vias 2003. For a function of the lead structure 209, refer to the foregoing description. Details are not described herein again.

It may be understood that, when the chip stacked structure 10 includes the third redistribution layer 201, the lead structure 209 may be electrically connected to the first through silicon vias 2003 through the third redistribution layer 201.

The chip stacked structure 10 is described above by using an example in which the chip stacked structure 10 includes the first chip 200 and the second chip 300. It should be understood that the chip stacked structure 10 includes but is not limited to the first chip 200 and the second chip 300. In some examples, as shown in FIG. 4a, the chip stacked structure 10 may further include a third chip 400. For a structure of the third chip 400, refer to the structure of the second chip 300.

When the chip stacked structure 10 includes the third chip 400, as shown in FIG. 4a, the second chip 300 further includes second through silicon vias 3004 that penetrate the second substrate 3001 and the second functional layer 3002. The second through silicon via 3004 is electrically connected to the first redistribution layer 301. A diameter of the second through silicon via 3004 close to the second functional layer 3002 is greater than a diameter of the second through silicon via close to the second substrate 3001. The third chip 400 includes a third substrate 4001 and a third functional layer 4002 disposed on the third substrate 4001. The chip stacked structure 10 further includes a fourth redistribution layer 401 disposed on a side that is of the third functional layer 4002 and that is away from the third substrate 4001, a second dielectric layer 410 disposed between the second substrate 3001 and the fourth redistribution layer 401, and a plurality of second bonding metal blocks 420 disposed in the second dielectric layer 410. At least some of the second bonding metal blocks 420 are electrically connected to the second through silicon vias 3004 and the fourth redistribution layer 401 respectively.

It should be noted that, for the second through silicon via 3004, refer to the foregoing first through silicon via 2003. Details are not described herein again.

Still refer to FIG. 4a, the second bonding metal block 420 includes a third bonding metal sub-block 309 and a fourth bonding metal sub-block 405 that are mutually bonded. The third bonding metal sub-block 309 is close to the second through silicon via 3004, and the fourth bonding metal sub-block 405 is close to the fourth redistribution layer 401.

Still refer to FIG. 4a, the second dielectric layer 410 includes a third dielectric sub-layer 306 and a fourth dielectric sub-layer 402 that are disposed in a stacked manner. The third dielectric sub-layer 306 is close to the second substrate 3001, the fourth dielectric sub-layer 402 is close to the fourth redistribution layer 401, and the third bonding metal sub-block 309 is disposed in the third dielectric sub-layer 306 and is exposed on a surface that is of the third dielectric sub-layer 306 and that is away from the second substrate 3001. The fourth bonding metal sub-block 405 is disposed in the fourth dielectric sub-layer 402, and is exposed on a surface that is of the fourth dielectric sub-layer 402 and that is away from the fourth redistribution layer 401.

In some examples, as shown in FIG. 4a, the third dielectric sub-layer 306 includes a plurality of third hybrid bonding vias 307 in a one-to-one correspondence with the second through silicon vias 3004, and the third bonding metal sub-block 309 is electrically connected to the second through silicon via 3004 through the third hybrid bonding via 307.

In some examples, as shown in FIG. 4a, the fourth dielectric sub-layer 402 includes a plurality of fourth hybrid bonding vias 403, and the fourth bonding metal sub-block 405 is electrically connected to the fourth redistribution layer 401 through the fourth hybrid bonding via 403.

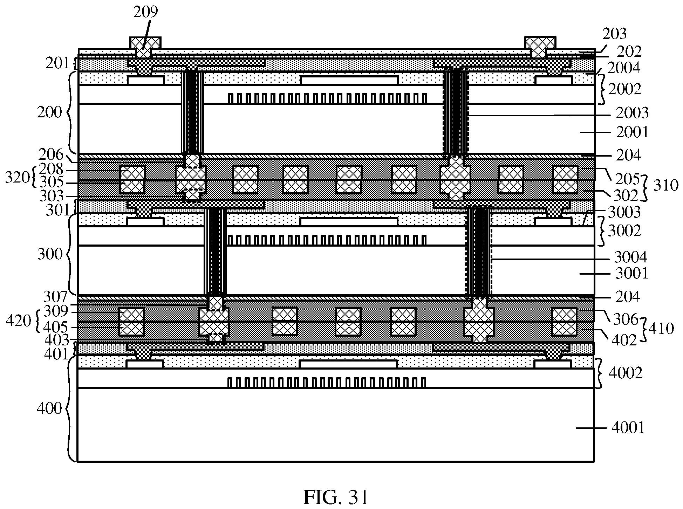

Based on this, when the first chip 200 includes the first through silicon vias 2003, and the second chip 300 includes the second through silicon vias 3004, as shown in FIG. 4a, a projection of the second through silicon vias 3004 on the first chip 200 has an overlapping area with the first through silicon vias 2003; or as shown in FIG. 31, a projection of the second through silicon vias 3004 on the first chip 200 has no overlapping area with the first through silicon vias 2003.

When the projection of the second through silicon vias 3004 on the first chip 200 has no overlapping area with the first through silicon vias 2003, stress concentration can be reduced.

When the chip stacked structure 10 further includes a fourth chip, a fifth chip, and the like, for structures of the fourth chip and the fifth chip and interconnection relationships between the fourth chip and the fifth chip and upper and lower chips, refer to the first chip 200, the second chip 300, and the third chip 400. Details are not described herein again.

An embodiment of this application further provides a chip stacked structure 10. As shown in FIG. 4a, the chip stacked structure 10 includes a first chip 200 and a second chip 300 that are sequentially stacked. The first chip 200 includes a first substrate 2001, a first functional layer 2002 disposed on the first substrate 2001, and first through silicon vias 2003 that penetrate the first substrate 2001 and the first functional layer 2002. The second chip 300 includes a second substrate 3001 and a second functional layer 3002 disposed on the second substrate 3001. The chip stacked structure 10 further includes a first redistribution layer 301 disposed on a side that is of the second functional layer 3002 and that is away from the second substrate 3001, a first dielectric layer 310 disposed between the first substrate 2001 and the first redistribution layer 301, and a plurality of first bonding metal blocks 320 disposed in the first dielectric layer 310. At least some of the first bonding metal blocks 320 are electrically connected to the first through silicon vias 2003 and the first redistribution layer 301 respectively.

The first chip 200 and the second chip 300 are bonded through the first dielectric layer 310 and the first bonding metal blocks 320, that is, the first chip 200 and the second chip 300 are bonded through hybrid bonding. The first through silicon via 2003 includes an electroplated column 2009 and a first conductive barrier layer 2007 that wraps a side surface of the electroplated column 2009, and the first conductive barrier layer 2007 is not disposed on a surface that is of the electroplated column 2009 and that is away from the second chip 200.

In some examples, the first conductive barrier layer 2007 is not disposed on a surface that is of the electroplated column 2009 and that is close to the second chip 200.

In some examples, a diameter of the first through silicon via 2003 close to the first functional layer 2002 is greater than or equal to a diameter of the first through silicon via close to the first substrate 2001.

It should be noted that the first chip 200 includes but is not limited to the first substrate 2001, the first functional layer 2002, and the first through silicon vias 2003. For other structures of the first chip 200, refer to the foregoing description. Details are not described herein again. The second chip 300 includes but is not limited to the second substrate 3001 and the second functional layer 3002. For another structure of the second chip 300, refer to the foregoing description. Details are not described herein again. In addition, for specific structures of the first dielectric layer 310 and the first bonding metal block 320 in the chip stacked structure 10, and other structures of the chip stacked structure 10, refer to the foregoing description. Details are not described herein again.

It should be understood that the chip stacked structure 10 includes but is not limited to the first chip 200 and the second chip 300, and may further include another chip. For structures of the another chip and interconnection relationships between the another chip and upper and lower chips, refer to the first chip 200, the second chip 300, and the third chip 400. Details are not described herein again.

In another aspect of this application, a non-transitory computer-readable storage medium used with a computer is further provided. The computer has software for creating and manufacturing the chip stacked structure 10. The computer-readable storage medium stores one or more computer-readable data structures. The one or more computer-readable data structures have control data, such as optical mask data, for manufacturing the chip stacked structure 10 provided in any one of the figures provided above.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip stacked structure, comprising:
a first chip, wherein the first chip comprises a first substrate, a first functional layer disposed on the first substrate, and first through silicon vias that penetrate the first substrate and the first functional layer, and a diameter of the first through silicon via close to the first functional layer is greater than a diameter of the first through silicon via close to the first substrate;
a second chip, wherein the second chip comprises a second substrate and a second functional layer disposed on the second substrate;
a first redistribution layer disposed on a side that is of the second functional layer and that is away from the second substrate; and
a first dielectric layer disposed between the first substrate and the first redistribution layer and a plurality of first bonding metal blocks disposed in the first dielectric layer, wherein at least some of the first bonding metal blocks are electrically connected to the first through silicon vias and the first redistribution layer respectively, and the first chip and the second chip are bonded through the first dielectric layer and the first bonding metal blocks.

2. The chip stacked structure according to claim 1, wherein the first through silicon via comprises an electroplated column and a first conductive barrier layer wrapping a side surface of the electroplated column, and the first conductive barrier layer is not disposed on a surface that is of the electroplated column and that is away from the second chip.

3. The chip stacked structure according to claim 2, wherein the first conductive barrier layer is not disposed on a surface that is of the electroplated column and that is close to the second chip.

4. The chip stacked structure according to claim 2 or 3, wherein a material of the first conductive barrier layer comprises one or more of titanium, titanium nitride, tantalum, or tantalum nitride.

5. The chip stacked structure according to any one of claims 1 to 4, wherein the first bonding metal block comprises a first bonding metal sub-block and a second bonding metal sub-block that are mutually bonded, the first bonding metal sub-block is close to the first through silicon via, and the second bonding metal sub-block is close to the first redistribution layer.

6. The chip stacked structure according to claim 5, wherein the first dielectric layer comprises a first dielectric sub-layer and a second dielectric sub-layer that are mutually bonded, the first dielectric sub-layer is close to the first substrate, and the second dielectric sub-layer is close to the first redistribution layer; and
the first bonding metal sub-block is disposed in the first dielectric sub-layer, and is exposed on a surface that is of the first dielectric sub-layer and that is away from the first substrate; and the second bonding metal sub-block is disposed in the second dielectric sub-layer, and is exposed on a surface that is of the second dielectric sub-layer and that is away from the first redistribution layer.

7. The chip stacked structure according to claim 6, wherein the first dielectric sub-layer comprises a plurality of first hybrid bonding vias in a one-to-one correspondence with the first through silicon vias, and the first bonding metal sub-blocks are electrically connected to the first through silicon vias through the first hybrid bonding vias; and/or
the second dielectric sub-layer comprises a plurality of second hybrid bonding vias, and the second bonding metal sub-blocks are electrically connected to the first redistribution layer through the second hybrid bonding vias.

8. The chip stacked structure according to any one of claims 1 to 7, wherein the chip stacked structure further comprises a second redistribution layer disposed between the first substrate and the first dielectric layer; and
the second redistribution layer is electrically connected to the first through silicon vias and the first bonding metal blocks respectively.

9. The chip stacked structure according to claim 8, wherein a projection of the first bonding metal blocks on the first chip has an overlapping area with the first through silicon vias; or
a projection of the first bonding metal blocks on the first chip has no overlapping area with the first through silicon vias.

10. The chip stacked structure according to any one of claims 1 to 9, wherein the chip stacked structure further comprises a first insulation barrier layer disposed between the first substrate and the first dielectric layer, the first insulation barrier layer comprises a plurality of hollow areas, and the first bonding metal blocks are electrically connected to the first through silicon vias through the hollow areas on the first insulation barrier layer.

11. The chip stacked structure according to any one of claims 1 to 10, wherein the chip stacked structure further comprises a third redistribution layer disposed on a side that is of the first functional layer and that is away from the first substrate; and
the third redistribution layer is electrically connected to the first through silicon vias.

12. The chip stacked structure according to any one of claims 1 to 11, wherein the second chip further comprises second through silicon vias that penetrate the second substrate and the second functional layer, the second through silicon vias are electrically connected to the first redistribution layer, and a diameter of the second through silicon via close to the second functional layer is greater than a diameter of the second through silicon via close to the second substrate; and
the chip stacked structure further comprises:
a third chip, wherein the third chip comprises a third substrate and a third functional layer disposed on the third substrate;
a fourth redistribution layer disposed on a side that is of the third functional layer and that is away from the third substrate; and
a second dielectric layer disposed between the second substrate and the fourth redistribution layer and a plurality of second bonding metal blocks disposed in the second dielectric layer, wherein at least some of the second bonding metal blocks are electrically connected to the second through silicon vias and the fourth redistribution layer respectively.

13. The chip stacked structure according to claim 12, wherein the second bonding metal block comprises a third bonding metal sub-block and a fourth bonding metal sub-block that are mutually bonded, the third bonding metal sub-block is close to the second through silicon via, and the fourth bonding metal sub-block is close to the fourth redistribution layer.

14. The chip stacked structure according to claim 13, wherein the second dielectric layer comprises a third dielectric sub-layer and a fourth dielectric sub-layer that are disposed in a stacked manner, the third dielectric sub-layer is close to the second substrate, and the fourth dielectric sub-layer is close to the fourth redistribution layer; and
the third bonding metal sub-block is disposed in the third dielectric sub-layer, and is exposed on a surface that is of the third dielectric sub-layer and that is away from the second substrate; and the fourth bonding metal sub-block is disposed in the fourth dielectric sub-layer, and is exposed on a surface that is of the fourth dielectric sub-layer and that is away from the fourth redistribution layer.

15. The chip stacked structure according to any one of claims 12 to 14, wherein a projection of the second through silicon vias on the first chip has an overlapping area with the first through silicon vias; or
a projection of the second through silicon vias on the first chip has no overlapping area with the first through silicon vias.

16. A chip stacked structure, comprising:
a first chip, wherein the first chip comprises a first substrate, a first functional layer disposed on the first substrate, and first through silicon vias that penetrate the first substrate and the first functional layer;
a second chip, wherein the second chip comprises a second substrate and a second functional layer disposed on the second substrate;
a first redistribution layer disposed on a side that is of the second functional layer and that is away from the second substrate; and
a first dielectric layer disposed between the first substrate and the first redistribution layer and a plurality of first bonding metal blocks disposed in the first dielectric layer, wherein at least some of the first bonding metal blocks are electrically connected to the first through silicon vias and the first redistribution layer respectively, wherein
the first chip and the second chip are bonded through the first dielectric layer and the first bonding metal blocks, the first through silicon via comprises an electroplated column and a first conductive barrier layer wrapping a side surface of the electroplated column, and the first conductive barrier layer is not disposed on a surface that is of the electroplated column and that is away from the second chip.

17. The chip stacked structure according to claim 16, wherein the first conductive barrier layer is not disposed on a surface that is of the electroplated column and that is close to the second chip.

18. The chip stacked structure according to claim 16 or 17, wherein a material of the first conductive barrier layer comprises one or more of titanium, titanium nitride, tantalum, or tantalum nitride.

19. The chip stacked structure according to any one of claims 16 to 18, wherein a diameter of the first through silicon via close to the first functional layer is greater than or equal to a diameter of the first through silicon via close to the first substrate.

20. A chip package structure, comprising a package substrate and the chip stacked structure according to any one of claims 1 to 19, wherein
the chip stacked structure is electrically connected to the package substrate.

21. An electronic device, comprising a printed circuit board and the chip package structure according to claim 20, wherein
the chip package structure is electrically connected to the printed circuit board.

22. A chip stacked structure manufacturing method, comprising:
forming first through silicon vias on a first chip from a side of a first functional layer of the first chip, wherein the first chip comprises a first substrate and the first functional layer disposed on the first substrate;
bonding a carrier and the first chip, wherein the first functional layer is close to the carrier relative to the first substrate;
forming a first redistribution layer on a second functional layer of a second chip, wherein the second chip comprises a second substrate and the second functional layer disposed on the second substrate; and
bonding the first chip and the second chip, and forming a first dielectric layer between the first substrate and the first redistribution layer and a plurality of first bonding metal blocks located in the first dielectric layer, wherein at least some of the first bonding metal blocks are electrically connected to the first through silicon vias and the first redistribution layer respectively.

23. The manufacturing method according to claim 22, wherein the first through silicon via does not penetrate the first substrate; and
after the bonding a carrier and the first chip, and before the bonding the first chip and the second chip, and forming a first dielectric layer between the first substrate and the first redistribution layer and a plurality of first bonding metal blocks located in the first dielectric layer, the manufacturing method further comprises:
thinning the first substrate from a side that is of the first substrate and that is away from the first functional layer to expose the first through silicon via.

24. The manufacturing method according to claim 22 or 23, wherein the forming a first dielectric layer between the first substrate and the first redistribution layer and a plurality of first bonding metal blocks located in the first dielectric layer comprises:
forming a first dielectric sub-layer and a plurality of first bonding metal sub-blocks on the first substrate, wherein the first bonding metal sub-block is disposed in the first dielectric sub-layer, and is exposed on a surface that is of the first dielectric sub-layer and that is away from the first substrate, and at least some of the first bonding metal sub-blocks are electrically connected to the first through silicon vias; and
forming a second dielectric sub-layer and a plurality of second bonding metal sub-blocks on the first redistribution layer, wherein the second bonding metal sub-block is disposed in the second dielectric sub-layer, and is exposed on a surface that is of the second dielectric sub-layer and that is away from the second substrate, and at least some of the second bonding metal sub-blocks are electrically connected to the first redistribution layer, wherein
the first dielectric layer comprises the first dielectric sub-layer and the second dielectric sub-layer, and the first bonding metal block comprises the first bonding metal sub-block and the second bonding metal sub-block.

25. The manufacturing method according to claim 24, wherein the first dielectric sub-layer comprises a plurality of first hybrid bonding vias in a one-to-one correspondence with the first through silicon vias, and the first bonding metal sub-blocks are electrically connected to the first through silicon vias through the first hybrid bonding vias; and/or
the second dielectric sub-layer comprises a plurality of second hybrid bonding vias, and the second bonding metal sub-blocks are electrically connected to the first redistribution layer through the second hybrid bonding vias.

26. The manufacturing method according to any one of claims 22 to 25, wherein after the bonding a carrier and the first chip, and before the bonding the first chip and the second chip, and forming a first dielectric layer between the first substrate and the first redistribution layer and a plurality of first bonding metal blocks located in the first dielectric layer, the manufacturing method further comprises:
forming a second redistribution layer on the first substrate, wherein the second redistribution layer is electrically connected to the first through silicon vias.

27. The manufacturing method according to any one of claims 22 to 26, wherein after the bonding a carrier and the first chip, and before the bonding the first chip and the second chip, and forming a first dielectric layer between the first substrate and the first redistribution layer and a plurality of first bonding metal blocks located in the first dielectric layer, the manufacturing method further comprises:
forming a first insulation barrier layer on a side that is of the first substrate and that is away from the first functional layer.

28. The manufacturing method according to any one of claims 22 to 27, wherein after the forming first through silicon vias on a first chip from a side of a first functional layer of the first chip, and before the bonding a carrier and the first chip, the manufacturing method further comprises: forming a third redistribution layer above the first functional layer, wherein the third redistribution layer covers the first through silicon vias and is electrically connected to the first through silicon vias.

29. The manufacturing method according to any one of claims 22 to 28, wherein before the forming a first redistribution layer on a second functional layer of a second chip, the manufacturing method further comprises:
forming second through silicon vias from a side of the second functional layer of the second chip; and
after the bonding the first chip and the second chip, and forming a first dielectric layer between the first substrate and the first redistribution layer and a plurality of first bonding metal blocks located in the first dielectric layer, the manufacturing method further comprises:
forming a fourth redistribution layer on a third functional layer of a third chip, wherein the third chip comprises a third substrate and a third functional layer disposed on the third substrate; and
bonding the second chip and the third chip, and forming a second dielectric layer between the second substrate and the fourth redistribution layer and a plurality of second bonding metal blocks located in the second dielectric layer, wherein at least some of the second bonding metal blocks are electrically connected to the second through silicon vias and the fourth redistribution layer respectively.

30. The manufacturing method according to claim 29, wherein the forming a second dielectric layer between the second substrate and the fourth redistribution layer and a plurality of second bonding metal blocks located in the second dielectric layer comprises:
forming a third dielectric sub-layer and a plurality of third bonding metal sub-blocks on the second substrate, wherein the third bonding metal sub-block is disposed in the third dielectric sub-layer, and is exposed on a surface that is of the third dielectric sub-layer and that is away from the second substrate, and at least some of the third bonding metal sub-blocks are electrically connected to the second through silicon vias; and
forming a fourth dielectric sub-layer and a plurality of fourth bonding metal sub-blocks on the fourth redistribution layer, wherein the fourth bonding metal sub-block is disposed in the fourth dielectric sub-layer, and is exposed on a surface that is of the fourth dielectric sub-layer and that is away from the third substrate, and at least some of the fourth bonding metal sub-blocks are electrically connected to the fourth redistribution layer, wherein
the second dielectric layer comprises a third dielectric sub-layer and a fourth dielectric sub-layer, and the second bonding metal block comprises the third bonding metal sub-block and the fourth bonding metal sub-block.

31. The manufacturing method according to claim 29 or 30, wherein the second through silicon via does not penetrate the second substrate; and
after the bonding the first chip and the second chip, and forming a first dielectric layer between the first substrate and the first redistribution layer and a plurality of first bonding metal blocks located in the first dielectric layer, and before the bonding the second chip and the third chip, and forming a second dielectric layer between the second substrate and the fourth redistribution layer and a plurality of second bonding metal blocks located in the second dielectric layer, the manufacturing method further comprises:
thinning the second substrate from a side that is of the second substrate and that is away from the second functional layer to expose the second through silicon via.
